# FASCICULE DE BREVET EUROPEEN

(11) **EP 3 522 372 B1**
(45) Date de publication et mention de la délivrance du brevet: **04.11.2026**
(21) Numéro de dépôt: 19154079.8
(22) Date de dépôt: 29.01.2019
(51) Int. Cl.: H03F 3/195, H03F 3/21, H03F 3/24, H03F 3/68

(54) **PROCÉDÉ ET SYSTÈME DE CALIBRATION D'UN SOUS-SYSTÈME MULTIVOIES RADIOFRÉQUENCE D'UNE CHARGE UTILE DE TÉLÉCOMMUNICATIONS**
VERFAHREN UND SYSTEM ZUR KALIBRIERUNG EINES MEHRWEGE-FUNKUNTERSYSTESMS EINER NUTZLAST DER TELEKOMMUNIKATION
METHOD AND SYSTEM FOR CALIBRATING A RADIOFREQUENCY MULTI-CHANNEL SUBSYSTEM OF A TELECOMMUNICATIONS PAYLOAD

(30) Priorité: 01.02.2018 FR 1800105
(43) Date de publication de la demande: 07.08.2019
(73) Titulaire: Thales, 92400 Courbevoie (FR); Centre National d'Etudes Spatiales, 75001 Paris (FR)
(72) Inventeur: BRIAND, Aline, 31037 TOULOUSE CEDEX 1 (FR); SOULEZ, Eddy, 31037 TOULOUSE CEDEX 1 (FR); LARUE DE TOURNEMINE, Cécile, 31037 TOULOUSE CEDEX 1 (FR); KAROUI, Walid, 31037 TOULOUSE CEDEX 1 (FR)
(74) Mandataire: Atout PI Laplace

(56) Documents cités:
- CN-A- 1 547 333
- KR-A- 20120 071 307
- US-A1- 2002 048 326
- US-A1- 2010 156 528
- US-A1- 2012 280 748
- US-A1- 2015 249 462
- US-A1- 2016 259 032
- AUBIN LECOINTRE: "Payload On-Board self calibration techniques", ESA'S ARTES PROGRAMMES, 17 February 2014 (2014-02-17), ESA's ARTES Programmes, XP055329026, Retrieved from the Internet <URL:https://artes.esa.int/projects/payload-board-self-calibration-techniques> [retrieved on 20161214]

## Description

La présente invention concerne un procédé de calibration embarqué d'un sous-système multivoies radiofréquence d'une charge utile, en particulier d'une charge utile flexible de télécommunications, ou toute autre charge utile embarquant un sous-système nécessitant l'appairage en amplitude/phase de plusieurs voies radiofréquence entre elles.

Le domaine technique concerne la calibration embarquée des sous-systèmes multivoies radiofréquences utilisés dans les charges utiles flexibles de télécommunications, et plus particulièrement la calibration des antennes semi-actives ou actives Tx émission ou réception Rx, déclinées suivant notamment les types DRA (en anglais Direct Radiating Array), AFSRA (en anglais Array Fed Shaped Reflector Antenna) et FAFR (en anglais Focal Array Fed Reflector), ou des sections d'amplification radiofréquence de puissance distribuée MPA (en anglais Multi-Port Amplifiers), formées par plusieurs amplificateurs de puissance, dénommés ATOPs (en anglais TWTAs « Traveling Wave Tube Amplifiers) lorsqu'ils utilisent des tubes à ondes progressives TOPs (en anglais « Traveling Wave Tubes » TWTs) et dénommés SSPAs (en anglais « Solid State Power Amplifiers » SSPAs) lorsqu'ils utilisent des composants de puissance à état solide.

Les charges utiles utilisent les antennes actives en émission Tx et/ou en réception Rx pour et utilisent des sections d'amplification radiofréquence de puissance distribuée MPA pour répartir de manière flexible plusieurs canaux de transmission vers plusieurs faisceaux de sortie.

On cherche encore actuellement à améliorer les solutions existantes de calibration de tels sous-systèmes multivoies radiofréquence, la calibration ayant lieu pendant que le satellite est en opération, à des moments particuliers sur la durée de vie desdits sous-systèmes multivoies où les performances d'écart d'amplitude et de phase entre voies auront trop dérivées par rapport à un besoin requis à cause par exemple d'une évolution des conditions externes de température appliquées aux sous-systèmes multivoies ou du vieillissement de leurs composants internes.

La problématique sous-jacente de la calibration de tels sous-systèmes multivoies est d'effectuer une calibration précise du sous-système multivoies alors qu'il transmet des porteuses de communications opérationnelles, c'est-à-dire obtenir l'appairage souhaité en amplitude et en phase des voies entre elles avec une précision suffisante, tout en assurant le maintien et l'intégrité de la qualité de transmission des communications en cours.

A cette fin et de manière connue, la demande de brevet US 2012/0280748 A1, formant un premier document, décrit un dispositif d'amplification répartie multi-ports, compensé en présence de trafic.

Suivant un premier mode de réalisation préféré, le dispositif d'amplification répartie multi-ports, compensé en présence de trafic, est configuré pour injecter un signal de référence non modulé et transmis sur une fréquence porteuse unique. La valeur de cette fréquence porteuse est choisie de façon à ce que le signal de référence soit introduit entre deux canaux de communication sans en altérer les performances.

Suivant un deuxième mode de réalisation et en variante, le signal de référence non modulé et transmis sur une porteuse unique du premier mode de réalisation est remplacé par un signal de référence sinusoïdal étalé spectralement à l'aide d'un code d'étalement. Dans ce cas, le dispositif de mesure du signal étalé, inclut en plus des composants utilisés par le module de mesure du signal non modulé un module de désétalement du signal reçu à partir du code d'étalement utilisé qui est fourni par un générateur de code d'étalement.

Suivant le dispositif d'amplification répartie multi-ports du premier document, le positionnement du signal de référence à injecter dans les bandes de garde entre les porteuses du trafic, dépend du plan de fréquences des porteuses de trafic provenant de la planification de la mission de télécommunications, ce qui manque de flexibilité.

De plus, les formes d'ondes proposées du signal de calibration ou de référence à injecter telles que décrites dans le premier document pour la calibration, c'est-à-dire celle d'un signal sinusoïdal simple non modulé CW ou celle d'un signal sinusoïdal, étalé spectralement à l'aide d'un code d'étalement, ne permettent pas d'injecter le signal de référence dans une porteuse utile de trafic dans tous les cas de configuration de la porteuse utile de trafic, par exemple une porteuse de modulation d'ordre élevé plus sensible au bruit ou de rapport signal à bruit élevé, ou dans les cas où la durée de calibration doit être limitée. En effet, la puissance du signal de calibration requise, devant être suffisamment basse pour ne pas gêner la transmission de la porteuse utile au sein de laquelle elle se trouve, pour respecter par exemple le critère de performance en Taux d'Erreurs Paquet de 10⁻⁷ quasiment sans erreur (Quasi Error Free) sur les porteuses utiles modulées codées en DVB-S2), ne permet pas d'estimer les disparités d'amplitude et de phase entre voies avec suffisamment de précision.

De manière connue, la demande de brevet US 2014/0354355 A1, formant un deuxième document, décrit un dispositif d'amplification répartie multi-ports MPA configuré pour maximiser l'isolation entre ses sorties par la mise en œuvre d'un procédé de calibration.

Le procédé de calibration utilise le signal de trafic lui-même pour calibrer les voies du MPA mais n'utilise aucun signal de calibration dédié, ayant une forme d'onde adaptée et injecté dans au moins une des voies du MPA.

Dans le cas où des porteuses de trafic sont exploitées en réutilisation de fréquence dans le MPA, la dégradation du rapport signal à bruit d'une de ces porteuses en sortie MPA, causée par des fuites d'isolation agrégées des autres porteuses co-fréquence, peut induire des estimations dispersives voire erronées des écarts d'amplitude et de phase inter-voies, entrainant une mauvaise calibration.

En outre, à chaque acquisition du signal de trafic sur une sortie du MPA, le signal de trafic correspondant en entrée du MPA doit être acquis simultanément pour pouvoir être comparé ou corrélé au signal de trafic en sortie. La solution décrite dans le deuxième document requiert ainsi l'utilisation d'un nombre de convertisseurs analogiques numériques (CAN) double de celui nécessaire dans un système de calibration classique comme celui décrit dans le premier document.

Ainsi, les systèmes et procédés de calibrations décrits dans les premier et deuxième documents, présentent des défauts ou inconvénients liés à des contraintes opérationnelles, notamment vis-à-vis de la planification en fréquence du trafic, ou liées à des limitations de performances d'estimation des erreurs entre voies. La demande de brevet US 2010/156528 A1, formant un troisième document, décrit également à l'instar du premier document un dispositif d'amplification répartie multiports, compensé en présence de trafic.

Un procédé et un système de calibration effectuant une calibration précise du sous-système multivoies alors qu'il transmet des porteuses de communications opérationnelles et évitant les inconvénients des systèmes des premier et deuxième documents précités sont recherchés. Le procédé et le système doivent permettre d'obtenir l'appairage souhaité en amplitude et en phase des voies entre elles avec une précision suffisante, tout en assurant le maintien et l'intégrité de la qualité de transmission des communications en cours.

La calibration du sous-système multivoies doit pouvoir être effectuée en bande étroite, par exemple sur 41MHz en bande L mais également sur une large bande de fréquence, par exemple sur 2GHz en bande Ku ou sur 2.9GHz en bande Ka.

Le problème technique est de fournir un procédé et un système de calibration d'un sous-système multivoies RF d'une charge utile de télécommunications qui permettent d'effectuer une calibration précise du sous-système multivoies, en même temps que la transmission des porteuses de trafic, non pénalisante pour la bande des fréquences utilisée par les porteuses de trafic, et indépendante de la position fréquentielle des porteuses de trafic.

A cet effet, l'invention a pour objet un procédé de calibration d'un sous-système multivoies radiofréquence d'une charge utile de télécommunications, la charge utile étant incluse en totalité dans et embarquée à bord d'un satellite ou distribuée sur un satellite et une station sol de formation de faisceaux, la calibration ayant lieu pendant que la charge utile est en opération. Le sous-système multivoies comprend : un premier nombre entier N, supérieur ou égal à 2, de voies d'accès en entrée, et un deuxième nombre entier M, supérieur ou égal à 1, de voies d'accès en sortie, et un ensemble d'au moins deux voies internes, formées chacune d'une chaine de composants radiofréquence de même architecture, soit distribuant un même signal d'entrée fourni par une voie d'accès en entrée sur plusieurs voies d'accès en sortie, soit concentrant plusieurs signaux d'entrée fournis respectivement par plusieurs voies d'accès en entrée sur une même voie d'accès en sortie. Le procédé de calibration comporte :
.- une première étape de génération et d'injection d'un signal de calibration en un point d'injection prédéterminé d'une voie d'accès d'entrée ou en plusieurs points prédéterminés associés chacun à une voie d'accès d'entrée différente, puis
.- une deuxième étape d'extraction du signal de calibration injecté et propagé en un point de prélèvement prédéterminé d'une voie d'accès de sortie ou en plusieurs points de prélèvement prédéterminés associés chacun à une voie d'accès de sortie différente, puis
.- une troisième étape d'estimation des écarts d'amplitude et/ou de phase entre les voies internes du sous-système multivoies à partir du signal de calibration injecté en entrée servant de référence et du ou des signaux de calibration extraits ; puis
.- une quatrième étape de correction des écarts d'amplitude et/ou phase par un ou plusieurs moyens de correction desdits écarts lorsqu'un ou plusieurs de ces derniers dépassent un seuil prédéterminé.

Dans le procédé de calibration selon l'invention, le signal de calibration injecté est un signal de type « CHIRP », composé d'un ou plusieurs mêmes motifs CHIRP dans lequel la fréquence varie linéairement dans une bande de fréquence donnée (BW_{chirp}). Le signal de calibration est injecté à un niveau de puissance suffisamment faible pour ne pas dégrader les performances de signaux de trafic transmis sur les voies d'accès. La deuxième étape d'extraction du signal de calibration comprend le filtrage du ou des signaux prélevés en un ou plusieurs points de sortie par un filtre adapté au signal de calibration.

Suivant des modes particuliers de réalisation, le procédé de calibration d'un sous-système multivoies radiofréquence comprend l'une ou plusieurs de caractéristiques suivantes prises isolément ou en combinaison :
.- chaque motif CHIRP du signal de calibration injecté de type « CHIRP » est un signal complexe s(t) de la forme *s*(*t*) *= a*(*t*)*.* exp{*j*. *φ*(*t*)} où *a*(*t*) ≥ 0 est une amplitude passe-bas dont l'évolution temporelle est lente par rapport aux oscillations de la phase *φ*(*t*) ;
.- le signal de calibration injecté est un signal de type « CHIRP » linéaire complexe périodisé s(t) de la forme *s*(*t*) *= A.* exp{*j*. *φ*(*t*)}, la fréquence instantanée : $f \left(t\right) = \frac{1}{2 π} ∗ \frac{dφ \left(t\right)}{dt} = F 1 + \frac{F 2 - F 1}{T 1} ∗ t$ évoluant suivant une fonction périodique de type dent de scie répétant suivant une période temporelle T1 un motif de rampe de fréquence variant linéairement entre une première valeur de fréquence F1 et une deuxième valeur de fréquence F2, la première valeur de fréquence F1 étant égale à ${F}_{ce} - \frac{{BW}_{chirp}}{2}$ et la deuxième valeur de fréquence F2 étant égale à ${F}_{ce} + \frac{{BW}_{chirp}}{2}$*, F_{ce}* désignant une fréquence centrale prédéterminée et *BW_{chirp}* désignant la largeur de bande du CHIRP ;

.- le positionnement fréquentiel du signal de calibration injecté de type CHIRP est indépendant du plan de fréquence des porteuses de trafic ;
.- le spectre du signal de calibration injecté de type « CHIRP » comporte un lobe principal qui a une largeur de bande *B_{chirp}* et qui est inclus en totalité dans la bande d'une porteuse de trafic ;
.- le spectre du signal de calibration injecté de type « CHIRP » comporte un lobe principal qui a une largeur de bande *B_{chirp}* et qui est inclus partiellement dans la bande d'une porteuse de trafic ;
.- le spectre du signal de calibration injecté de type « CHIRP » comporte un lobe principal qui a une largeur de bande *B_{chirp}* et qui est inclus en totalité dans une bande de garde des porteuses de trafic ;
.- la première étape consiste à générer et injecter des signaux de calibration en un point d'injection prédéterminé d'une voie d'accès d'entrée ou en plusieurs points prédéterminés associés chacun à une voie d'accès d'entrée différente, et les signaux de calibration injectés sont des signaux de type « CHIRP » de même largeur de bande centrés à des fréquences centrales différentes réparties régulièrement sur la bande de communication des porteuses de trafic ;
.- le signal de calibration injecté est un signal de type « CHIRP » linéaire complexe périodisé s(t) de la forme *s*(*t*) *= A.* exp{*j*. *φ*(*t*)} ;I a fréquence instantanée f(t), exprimée par les équations : $f \left(t\right) = \frac{1}{2 π} ∗ \frac{dφ \left(t\right)}{dt} = F 1 + \frac{F 2 - F 1}{T 1} ∗ t$ évoluant suivant une fonction périodique de type dent de scie répétant suivant une période temporelle T1 un motif de rampe de fréquence variant linéairement entre une première valeur de fréquence F1 et une deuxième valeur de fréquence F2, la première valeur de fréquence F1 étant égale à ${F}_{ce} - \frac{{BW}_{chirp}}{2}$ et la deuxième valeur de fréquence F2 étant égale à ${F}_{ce} + \frac{{BW}_{chirp}}{2}$ *, F_{ce}* désignant une fréquence centrale prédéterminée et *BW_{chirp}* désignant la largeur de bande du CHIRP ; et au cours de la troisième étape, les écarts d'amplitude Δ*A* et/ou de phase Δ*Phi* entre les voies internes du sous-système multivoies sont estimés à partir du signal de calibration injecté en entrée servant de référence et du ou des signaux prélevées en sortie, en extrayant pour chaque voie interne le signal de calibration du signal de trafic par un filtrage adapté qui maximise le rapport signal sur bruit du signal de calibration et qui maximise une fonction de corrélation entre les échantillons du signal prélevé en sortie et les échantillons du signal de calibration comme réplique de référence, et en estimant l'amplitude A et la phase Phi de chaque voie interne à partir du maximum de corrélation donnant le gain complexe et retard de propagation du signal de calibration depuis son point d' injection numérique jusqu'en sortie du filtrage adapté ; puis en calculant les écarts Δ*A*/ Δ*Phi* des voies internes relativement à une voie de référence prédéterminée à partir des amplitude et phase estimés A/Phi de chaque voie ;
.- lorsque la charge utile de télécommunication est incluse en totalité dans et embarquée à bord d'un satellite, le système multivoies radiofréquence est un MPA comportant deux matrices de Butler, avec la matrice de Butler d'entrée numérique ou analogique, sans réseau de formation de faisceaux BFN, intégré dans une antenne active ou pas ; ou un MPA avec un réseau de formation de faisceaux BFN en entrée numérique ou analogique et une matrice de Butler en sortie, intégré au sein d'une antenne active ou pas ; ou un amplificateur multiport parallélisé MPPA comportant des amplificateurs parallélisés à l'intérieur d'un MPA, intégré au sein d'une antenne active ou pas ; ou une antenne semi-active dite « Multimatrix » avec réflecteur, avec ou sans MPA ; ou une antenne active de type réseau à rayonnement direct DRA ou une antenne à sous-réflecteur alimenté par un réseau de sources AFSRA ou une antenne à réflecteur alimenté en son point focal par un réseau de sources FAFR avec un BFN analogique ou numérique ; ou une fonction à bord nécessitant l'appairage en amplitude/phase de plusieurs voies entre elles ; et lorsque la charge utile de télécommunication est distribuée sur un satellite et une station sol de formation de faisceaux, le système multivoies radiofréquence est une antenne active satellitaire en mode réception Rx avec formation effective de faisceaux au sol GBBF; ou une antenne active satellitaire en mode émission Tx avec formation effective de faisceaux au sol GBBF, avec ou sans une fonction MPA ou MPPA entièrement à bord ou avec ou sans une fonction MPA ou MPPA dont la matrice de Butler d'entrée est distribuée au sol ;
.- la quatrième étape est exécutée directement à bord du satellite ou au sol.

L'invention a également pour objet un système de calibration d'un sous-système multivoies radiofréquence d'une charge utile de télécommunications, la charge utile étant incluse en totalité dans et embarquée à bord d'un satellite ou distribuée sur un satellite et une station sol de formation de faisceaux, la calibration ayant lieu pendant que la charge utile est en opération.

Le sous-système multivoies comprend un premier nombre entier N, supérieur ou égal à 2, de voies d'accès en entrée, et un deuxième nombre entier M, supérieur ou égal à 2, de voies d'accès en sortie, et un ensemble d'au moins deux voies internes, formées chacune d'une chaine de composants radiofréquence de même architecture, soit distribuant un même signal d'entrée fourni par une voie d'accès en entrée sur plusieurs voies d'accès en sortie, soit concentrant plusieurs signaux d'entrée fournis respectivement par plusieurs voies d'accès en entrée sur une même voie d'accès en sortie.

Le système de calibration comprend un premier dispositif d'injection d'un signal de calibration analogique ou numérique en un point d'injection prédéterminé d'une voie d'accès d'entrée ou en plusieurs points prédéterminés associés chacun à une voie d'accès d'entrée différente ; et un deuxième dispositif de prélèvement du signal de calibration injecté et propagé en un point de prélèvement prédéterminé d'une voie d'accès de sortie ou en plusieurs points de prélèvement prédéterminés associés chacun à une voie d'accès de sortie différente ; et un troisième dispositif de calcul numérique, formé d'un ou plusieurs calculateurs électroniques, et configuré pour : générer un signal de calibration numérique correspondant à la version numérique ou analogique du signal de calibration injecté par le premier dispositif ; et extraire le signal de calibration injecté à partir du ou des signaux prélevés en le point de prélèvement prédéterminé d'une voie d'accès de sortie ou en les points de prélèvement prédéterminés associés chacun à une voie d'accès de sortie différente et du signal de calibration généré ; estimer des écarts d'amplitude et/ou de phase entre les voies internes du sous-système multivoies à partir du signal de calibration injecté en entrée servant de référence et du ou des signaux de calibration extraits ; et corriger des écarts d'amplitude et/ou phase en commandant un ou plusieurs moyens de correction desdits écarts lorsqu'un ou plusieurs de desdits écarts dépassent un seuil prédéterminé. Le signal de calibration injecté est un signal de type « CHIRP », composé d'un ou plusieurs mêmes motifs CHIRP, dans lequel la fréquence varie linéairement dans une bande de fréquence donnée (BW_{chirp}). Le signal de calibration est injecté à un niveau de puissance suffisamment faible pour ne pas dégrader les performances de signaux de trafic transmis sur les voies d'accès. L'extraction du signal de calibration comprend le filtrage du ou des signaux prélevés en un ou plusieurs points de sortie par un filtre adapté au signal de calibration.

Suivant des modes particuliers de réalisation, le système de calibration d'un sous-système multivoies comprend l'une ou plusieurs de caractéristiques suivantes prises isolément ou en combinaison :
.- le signal de calibration injecté est un signal de type « CHIRP » linéaire complexe périodisé s(t) de la forme *s*(*t*) *= A.* exp{*j*. *φ*(*t*)}, la fréquence instantanée f(t), définie par les équations : $f \left(t\right) = \frac{1}{2 π} ∗ \frac{dφ \left(t\right)}{dt} = F 1 + \frac{F 2 - F 1}{T 1} ∗ t ,$ évoluant suivant une fonction périodique de type dent de scie répétant suivant une période temporelle T1 un motif de rampe de fréquence variant linéairement entre une première valeur de fréquence F1 et une deuxième valeur de fréquence F2, la première valeur de fréquence F1 étant égale à ${F}_{ce} - \frac{{BW}_{chirp}}{2}$ et la deuxième valeur de fréquence F2 étant égale à ${F}_{ce} + \frac{{BW}_{chirp}}{2}$ , *F_{ce}* désignant une fréquence centrale prédéterminée et *BW_{chirp}* désignant la largeur de bande de chacun des CHIRPs ; et le positionnement fréquentiel du signal de calibration injecté de type « CHIRP » est indépendant du plan de fréquence des porteuses de trafic ;
.- les premier et deuxième dispositifs sont configurés pour générer et injecter des signaux de calibration en un point d'injection prédéterminé d'une voie d'accès d'entrée ou en plusieurs points prédéterminés associés chacun à une voie d'accès d'entrée différente, et les signaux de calibration injectés sont des signaux de type « CHIRP » de même largeur de bande centrés à des fréquences centrales différentes réparties régulièrement sur la bande de communication des porteuses de trafic ;
.- lorsque la charge utile de télécommunication est incluse en totalité dans et embarquée à bord d'un satellite, le système multivoies radiofréquence est un MPA comportant deux matrices de Butler, avec la matrice de Butler d'entrée numérique ou analogique, sans réseau de formation de faisceaux BFN, intégré au sein d'une antenne active ou pas ; ou un MPA avec un réseau de formation de faisceaux BFN en entrée numérique ou analogique et une matrice de Butler en sortie, intégré au sein d'une antenne active ou pas ; ou un amplificateur multiport parallélisé MPPA comportant des amplificateurs parallélisés à l'intérieur d'un MPA, intégré au sein d'une antenne active ou pas ; ou une antenne semi-active dite « Multimatrix » avec réflecteur, avec ou sans MPA ; ou une antenne active de type réseau à rayonnement direct DRA ou une antenne à sous-réflecteur alimenté par un réseau de sources AFSRA ou une antenne à réflecteur alimenté en son point focal par un réseau de sources FAFR avec un BFN analogique ou numérique ; ou une fonction à bord nécessitant l'appairage en amplitude/phase de plusieurs voies entre elles ; et lorsque la charge utile de télécommunication est distribuée sur un satellite et une station sol de formation de faisceaux, le système multivoies radiofréquence est une antenne active satellitaire en mode réception Rx avec formation effective de faisceaux au sol GBBF, ou une antenne active satellitaire en mode émission Tx avec formation effective de faisceaux au sol GBBF, avec ou sans une fonction MPA ou MPPA entièrement à bord ou avec ou sans une fonction MPA ou MPPA dont la matrice de Butler d'entrée est distribuée au sol.

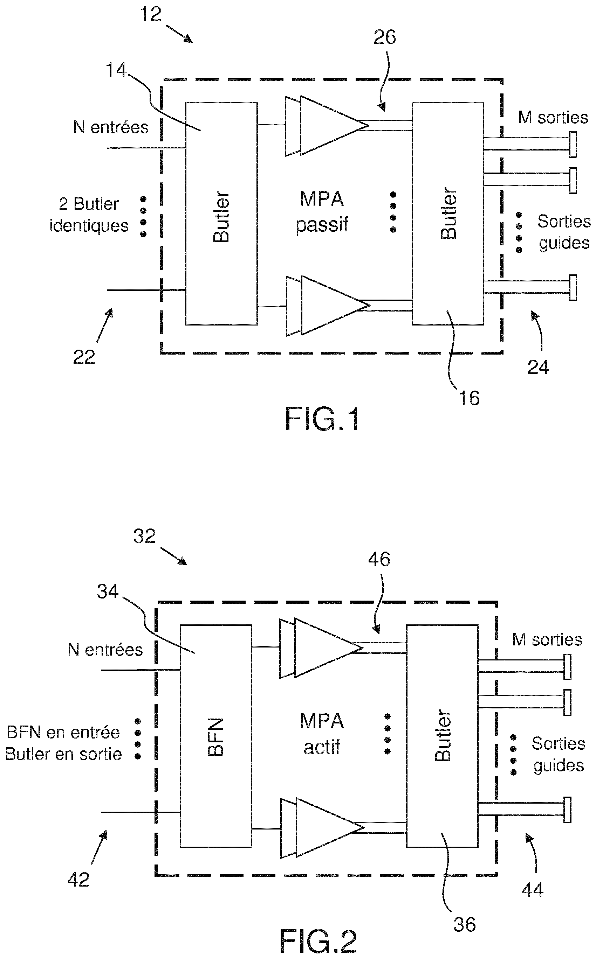

L'invention sera mieux comprise à la lecture de la description de plusieurs formes de réalisation qui va suivre, donnée uniquement à titre d'exemple et faite en se référant aux dessins sur lesquels :
.- la Figure 1 est une vue d'un premier exemple de sous-système multivoies, un MPA dit passif en référence aux matrices de Butler passives qui y sont utilisées, qui fait partie d'une charge utile de télécommunications embarquée à bord d'un satellite et peut avantageusement être calibré par un système et un procédé de calibration selon l'invention ;
.- la Figure 2 est une vue d'un deuxième exemple de sous-système multivoies, un MPA dit actif en référence à une matrice active (ou BFN) analogique ou numérique permettant de charger des lois d'amplitude et phase sur chaque voie de chaque faisceau, qui fait partie d'une charge utile de télécommunications embarquée à bord d'un satellite et peut avantageusement être calibré par un système et un procédé de calibration selon l'invention ;

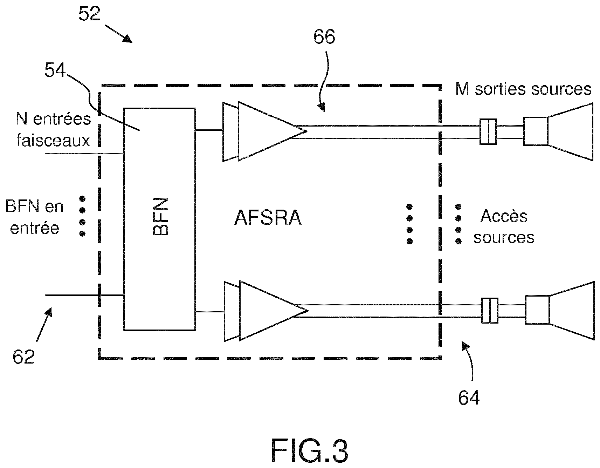

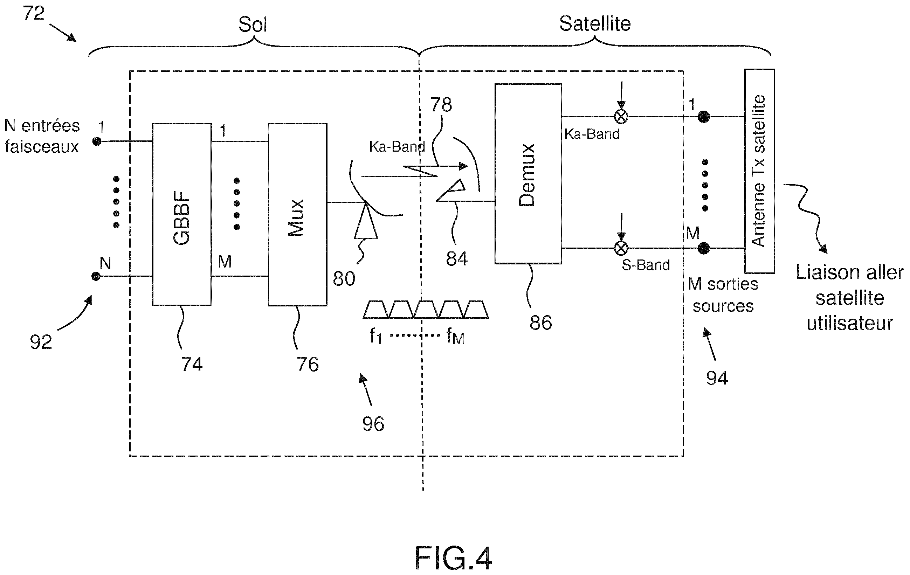

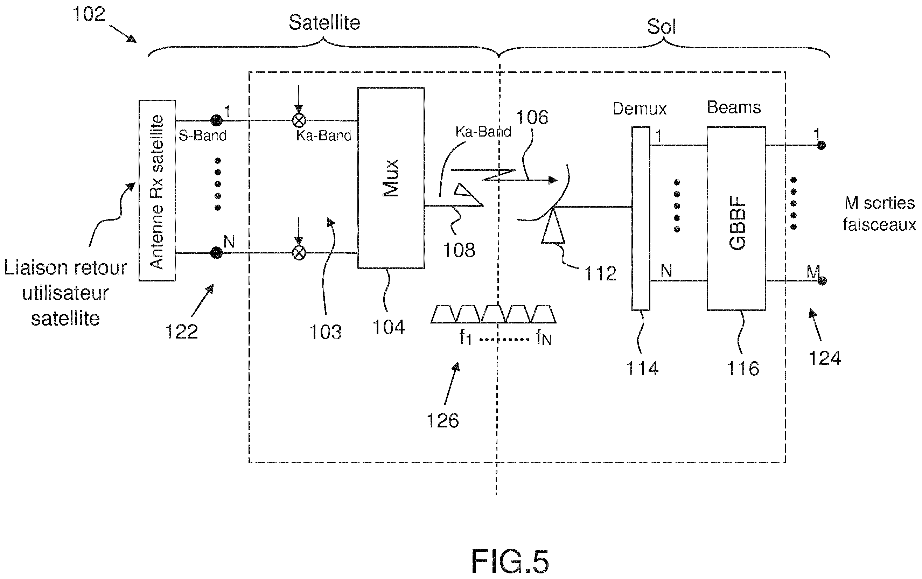

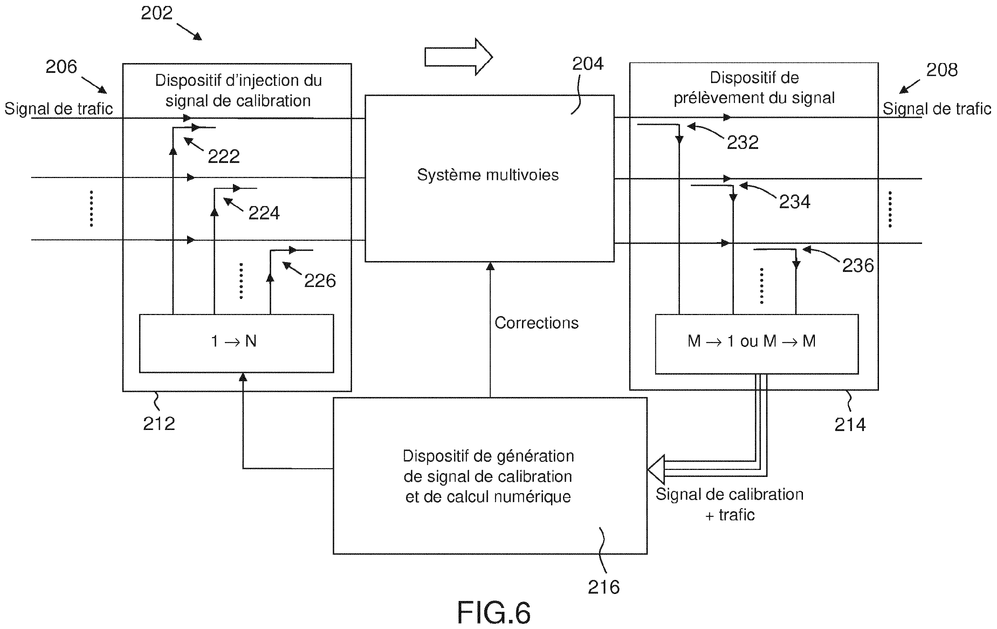

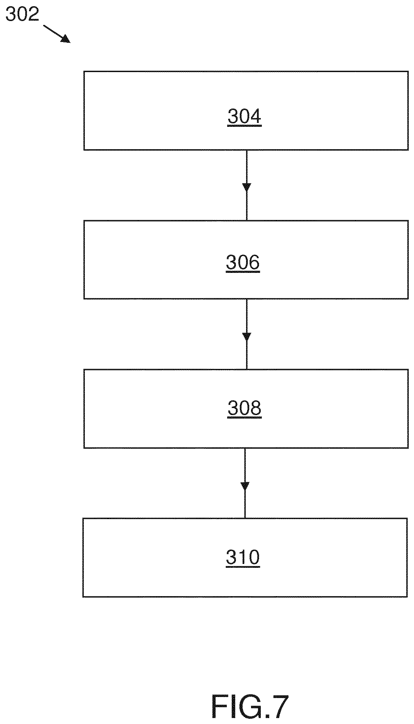

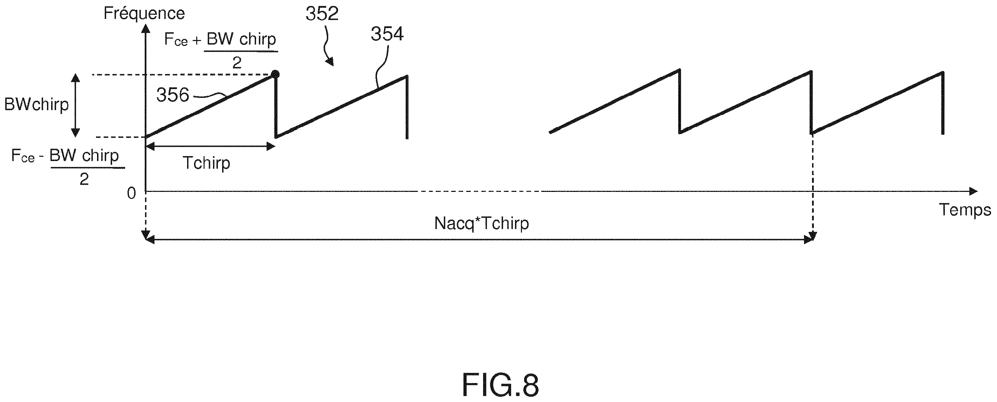

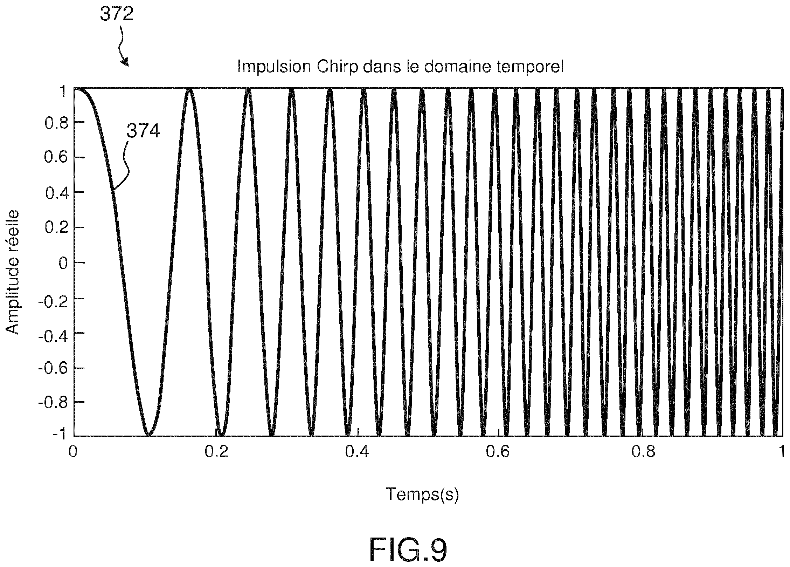

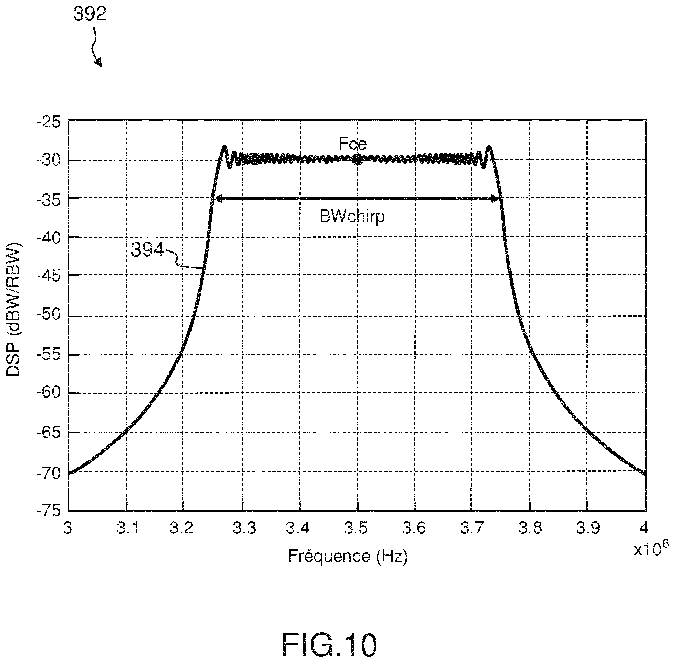

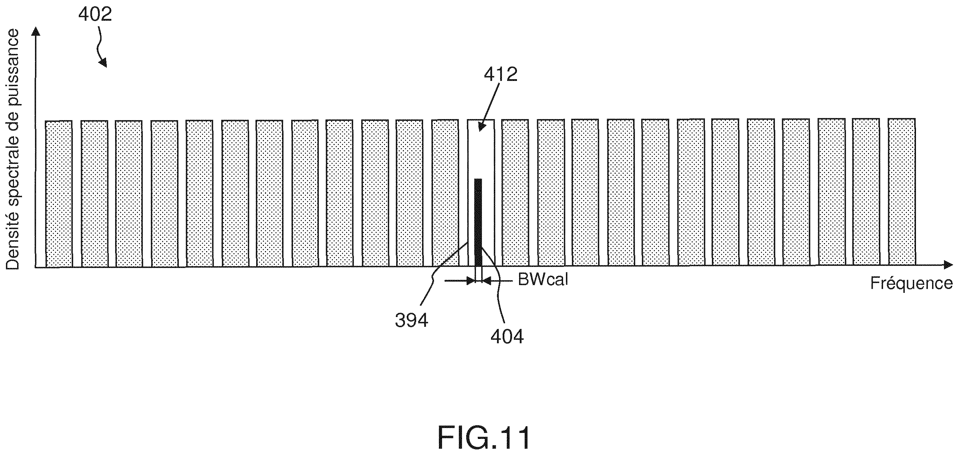

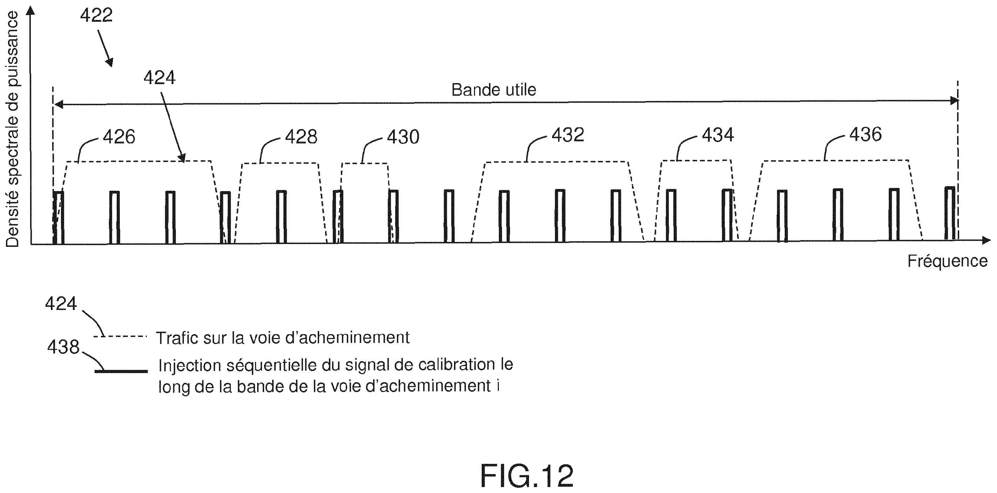

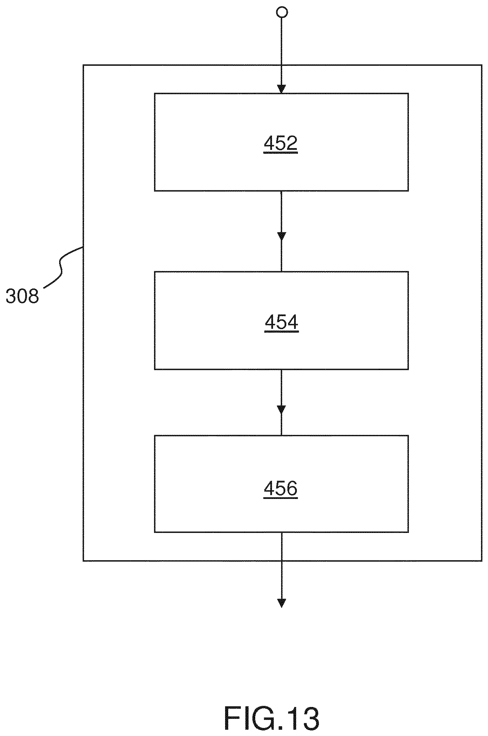

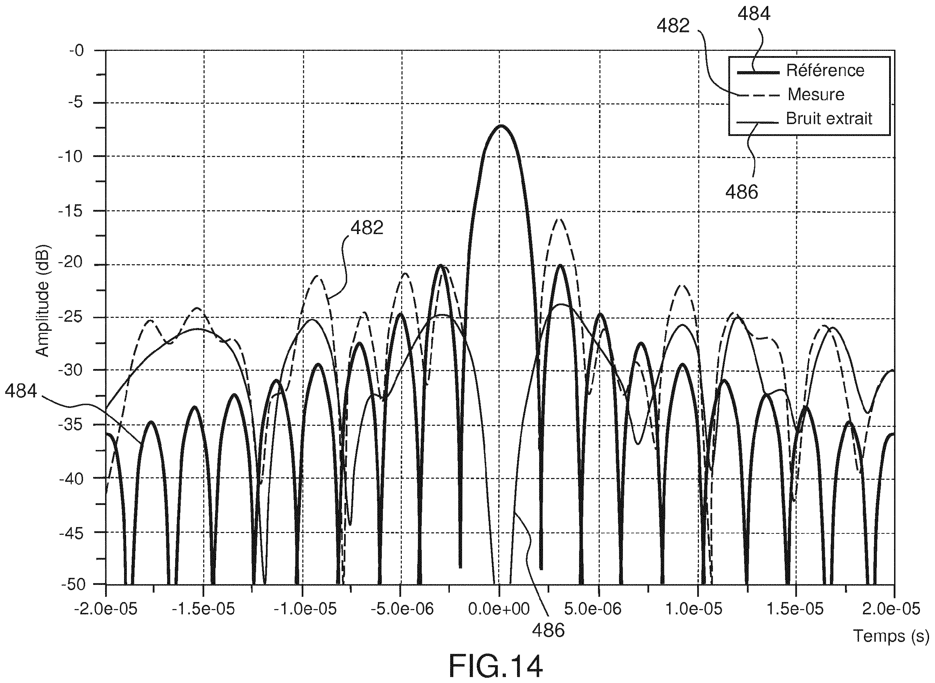

.- la Figure 3 est une vue d'un troisième exemple de sous-système multivoies radiofréquence, une antenne active à sous-réflecteur alimenté par un réseau de sources AFSRA en mode émission Tx qui fait partie d'une charge utile de télécommunications embarquée à bord d'un satellite et peut avantageusement être calibré par un système et un procédé de calibration selon l'invention ;
.- la Figure 4 est une vue d'un quatrième exemple de sous-système multivoies radiofréquence, une antenne active de voie aller qui fait partie d'une charge utile de télécommunications multifaisceaux distribuée sur un satellite et une station sol de formation de faisceaux et peut avantageusement être calibrée par un système et un procédé de calibration selon l'invention ;
.- la Figure 5 est une vue d'un cinquième exemple de sous-système multivoies radiofréquence, une antenne active de voie retour qui fait partie d'une charge utile de télécommunications multifaisceaux distribuée sur un satellite et une station sol de formation de faisceaux et peut avantageusement être calibrée par un système et un procédé de calibration selon l'invention ;
.- la Figure 6 est une vue générale d'un système de calibration selon l'invention d'un sous-système multivoies radiofréquence d'une charge utile de télécommunications comme par exemple ceux des Figures 1 à 5 ;
.- la Figure 7 est un ordinogramme d'un procédé de calibration selon l'invention d'un sous-système multivoies radiofréquence d'une charge utile de télécommunications comme par exemple ceux des Figures 1 à 5
.- la Figure 8 est une vue générale de l'évolution temporelle de la fréquence d'un signal de calibration injecté correspondant à un mode de réalisation préféré de l'invention ;
.- la Figure 9 est une vue d'un exemple d'évolution temporelle de la partie réelle de l'amplitude d'un motif d'un signal de calibration injecté correspondant à un exemple du mode de réalisation préféré du signal de calibration injecté suivant l'invention décrit à la Figure 8 ;
.- la Figure 10 est une vue d'un exemple de spectre typique d'un signal de calibration ayant la forme d'évolution fréquentielle décrite dans la Figure 8 ;
.- la Figure 11 est une vue d'un exemple du spectre utilisé par des porteuses de trafic d'une charge utile de télécommunications dans lequel le spectre du signal de calibration est noyé en totalité dans le spectre d'une porteuse avec une puissance d'interférence suffisamment négligeable pour ne pas perturber le trafic sur cette porteuse tout en permettant une calibration et une estimation précise des disparités amplitude/phase entrevoies ;
.- la Figure 12 est une vue d'un autre exemple du spectre utilisé par des signaux de trafic transitant sur une voie i de transmission de la charge utile de télécommunications et du spectre utilisé par le signal de calibration lorsqu'il est injecté séquentiellement le long de la bande utile de la voie i de transmission ;
.- la Figure 13 est un ordinogramme détaillée d'un mode de réalisation de l'étape d'extraction du signal de calibration du procédé de calibration selon l'invention de la Figure 7 ;
.- la Figure 14 est une vue comparative de la fonction de corrélation maximisée par filtrage adaptée d'un signal de calibration CHIRP de référence et d'un signal de calibration CHIRP extrait utilisant la forme d'onde dont les exemples de caractéristiques sont décrites dans les Figures 8 à 10.

Le concept de base de l'invention réside dans l'utilisation d'un signal de calibration dédié à la fonction calibration et dans la mise en œuvre classique des quatre étapes suivantes consistant à :
.- injecter un signal de calibration en un ou des points d'injection précis d'un sous-système multivoies radiofréquence d'une charge utile de télécommunications, et
.- extraire ce signal de calibration en un ou plusieurs points de prélèvement et de sortie dudit sous-système à calibrer, et
.- estimer des écarts d'amplitude et/ou de phase entre les voies internes du sous-système, et
.- corriger éventuellement des écarts d'amplitude et/ou de phase avec des moyens électroniques adaptés, par exemple des moyens ayant une fonction de déphaseur numérique et implémentés dans un des équipements du sous-système multivoies. Ces corrections peuvent alternativement être définies au sol à partir des estimations des écarts amplitude/phase calculées à bord et transmises au sol, puis appliquées à bord.

Le concept de base de l'invention réside dans la capacité du système de calibration à calibrer un sous-système multivoies avec un signal de calibration qui peut être « noyé » dans une porteuse de trafic, qui peut avoir un positionnement indépendant du plan de fréquences des porteuses de trafic, et qui permet d'obtenir en même temps la qualité exigée des performances de calibration et la non-dégradation de la qualité de transmission d'une porteuse de trafic interférée éventuellement par le signal de calibration.

Le concept de base de l'invention est fondé sur la nature particulière de la forme d'onde du signal de calibration utilisé qui est celle d'un signal de type « CHIRP », associée à un traitement spécifique de ce signal de type « CHIRP ». Ainsi, le signal de calibration peut être placé n'importe où dans la bande de fréquence allouée au service de télécommunication de la charge utile, en particulier dans une porteuse de trafic qui interfère dans ce cas avec le signal de calibration.

Le système et le procédé de calibration selon l'invention sont configurés pour calibrer une large famille de sous-systèmes multivoies radiofréquence, faisant partie chacun d'une charge utile de télécommunications.

La fonction du sous-système multivoies peut être incluse en totalité dans et embarquée à bord de la charge utile d'un satellite ou peut être distribuée sur un satellite et une station sol de formation de faisceaux, la calibration ayant lieu pendant que la charge utile est en opération.

De manière générale, un sous-système multivoies calibré par un système de calibration selon l'invention comprend :
.- un premier nombre entier N, supérieur ou égal à 2, de voies d'accès en entrée, et
.- un deuxième nombre entier M, supérieur ou égal à 2, de voies d'accès en sortie, et
.- un ensemble d'au moins deux voies internes, formées chacune d'une chaine de composants radiofréquence de même architecture, soit distribuant un même signal d'entrée fourni par une voie d'accès en entrée sur plusieurs voies d'accès en sortie, soit concentrant plusieurs signaux d'entrée fournis respectivement par plusieurs voies d'accès en entrée sur une même voie d'accès en sortie.

Lorsque la fonction du sous-système multivoies est incluse en totalité dans et embarquée à bord de la charge utile d'un satellite, le système multivoies radiofréquence est :
.-un MPA comportant deux matrices de Butler avec la matrice de Butler d'entrée numérique ou analogique sans réseau de formation de faisceaux BFN, intégré au sein d'une antenne active ou pas ; ou
.- un MPA avec un réseau de formation de faisceaux BFN (en anglais Beam Forming Network) en entrée numérique ou analogique et une matrice de Butler en sortie, intégré au sein d'une antenne active ou pas ; ou
.- un amplificateur parallélisé à ports multiples MPPA (en anglais Multi Port Parallelized Amplifier) comportant des amplificateurs parallélisés à l'intérieur d'un MPA, intégré au sein d'une antenne active ou pas ; ou
.- une antenne active de type réseau à rayonnement direct DRA ou une antenne à sous-réflecteur alimenté par un réseau de sources AFSRA ou une antenne à réflecteur alimenté en son point focal par un réseau de sources FAFR avec un BFN analogique ou numérique ; ou
.- une antenne semi-active dite « Multimatrix » avec réflecteur, avec ou sans MPA ; ou
.- toute autre fonction à bord d'un satellite de télécommunications, d'observation, de navigation, etc., qui nécessiterait l'appairage en amplitude/phase de plusieurs voies entre elles, même non citée dans ce document.

Suivant la Figure 1 et un premier exemple de sous-système multivoies, un MPA passif 12, faisant partie d'une charge utile de télécommunications embarquée à bord d'un satellite, comporte deux matrices de Butler 14, 16 sans réseau de formation de faisceaux BFN, un ensemble 22 de N voies d'accès en entrée, un ensemble 24 de M voies d'accès en sortie et un ensemble 26 d'au moins deux voies internes, formées ici par des chaines d'amplification. Lorsque les matrices de Butler ont les mêmes nombres d'entrées que de sorties, M est égal à N.

Suivant la Figure 2 et un deuxième exemple de sous-système multivoies, un MPA actif 32, faisant partie d'une charge utile de télécommunications embarquée à bord d'un satellite, comporte en entrée un réseau de formation de faisceaux BFN 34, numérique ou analogique, une matrice de Butler 36 en sortie, un ensemble 42 de N voies d'accès en entrée, un ensemble 44 de M voies d'accès en sortie et un ensemble 46 d'au moins deux voies internes, formées ici par des chaines d'amplification.

Suivant la Figure 3 et un troisième exemple de sous-système multivoies radiofréquence, une antenne active 52 à sous-réflecteur alimenté par un réseau de sources AFSRA et en mode émission Tx, faisant partie d'une charge utile de télécommunications embarquée à bord d'un satellite, comporte un réseau BFN 54 de formation de faisceaux Tx, numérique ou analogique, un ensemble 62 de N voies d'accès en entrée, un ensemble 64 de M voies d'accès en sortie et un ensemble 66 d'au moins deux voies internes, formées ici par des chaines d'amplification de puissance RF.

Lorsque la fonction du sous-système multivoies est distribuée sur la charge utile de télécommunications est à bord d'un satellite et sur une station sol de formation de faisceaux, le système multivoies radiofréquence est :
.- une antenne active satellitaire en mode réception Rx avec formation effective de faisceaux au sol GBBF (en anglais Ground Based Beam Forming) ; ou
.- une antenne active satellitaire en mode émission Tx avec formation effective de faisceaux au sol GBBF avec ou sans une fonction MPA ou MPPA entièrement à bord ou avec ou sans une fonction MPA ou MPPA dont la matrice de Butler d'entrée est distribuée aui sol.

Suivant la Figure 4 et un quatrième exemple de sous-système multivoies radiofréquence, une antenne active 72 en mode émission Tx de voie aller fait partie d'une charge utile de télécommunications multifaisceaux en étant distribuée sur un satellite et une station sol de formation de faisceaux GBBF, et comprend :
.- au niveau sol un module 74 de formation de faisceaux GBBF, un multiplexeur 76 de concentration des canaux de sorties du module 74 GBBF, et un ensemble émetteur-antenne RF émission Tx 80, configuré pour transmettre le flux multiplex au satellite sur une liaison RF 78 haut débit ;
.- au niveau satellite un ensemble antenne-récepteur RF 84 de réception RF du flux multiplex, un démultiplexeur 86 pour dé-multiplexer le flux multiplex en des canaux sources destinés à alimenter l'antenne Tx multifaisceaux ;

.- au niveau sol, un ensemble 92 de N voies d'accès en entrée de faisceaux de l'antenne active Tx multifaisceaux, et au niveau satellite, un ensemble 94 de M voies d'accès en sortie connectées aux sources de l'antenne Tx multifaisceaux ;
.- un ensemble 96 d'au moins deux voies internes, formées ici par le module 74 GBBF, le multiplexeur 76, l'ensemble émetteur-antenne RF émission Tx 80, la liaison RF montante 78 haut débit mono-faisceau, l'ensemble antenne-récepteur RF 84 de réception RF du flux multiplex, le démultiplexeur 86, et éventuellement un ensemble de M chaines de transposition/amplification associées et connectées chacune en amont d'un accès en sortie différent.

En variante le sous-système multivoies à calibrer peut être la portion de l'antenne active 72 en mode émission, comprise entre la sortie du module 74 GBBF et l'entrée 94 des sources de l'antenne Tx.

Suivant la Figure 5 et un cinquième exemple de sous-système multivoies radiofréquence, une antenne active multifaisceaux 102 en mode réception Rx de voie retour fait partie d'une charge utile de télécommunications multifaisceaux distribuée en étant distribuée sur un satellite et une station sol de formation de faisceaux GBBF, et comprend :
.- au niveau satellite, un ensemble 103 de N chaines d'amplification et/ou transposition connectées chacune à une source différente de l'antenne active Rx multifaisceaux, un multiplexeur 104 des canaux sources, éventuellement transposés, en un signal multiplex composite, et un ensemble émetteur-antenne émission Tx 108 mono-faisceau, configuré pour transmettre le flux à la station sol sur une liaison RF descendante 106 haut débit ;
.- au niveau sol, un ensemble antenne-récepteur RF 112 de réception du flux multiplex, un démultiplexeur 114 pour dé-multiplexer le flux multiplex en des canaux sources, et un module de formation de faisceaux 116 GBBF des faisceaux Rx ;
.- au niveau satellite, un ensemble 122 de N voies d'accès en entrée de sources de l'antenne active Rx multifaisceaux, et au niveau sol, un ensemble 124 de M voies d'accès en sortie faisceaux Rx de voie retour ;
.- un ensemble 126 d'au moins deux voies internes, formées ici par l'ensemble 103 de N chaines d'amplification et/ou transposition, le multiplexeur 104 des canaux sources, l'ensemble émetteur-antenne RF satellite émission Tx 108, la liaison RF descendante 106 haut débit mono-faisceau, l'ensemble antenne-récepteur RF 112 sol de réception RF du flux multiplex des canaux sources, le démultiplexeur 114, et le module de formation de faisceaux 116 GBBF des faisceaux Rx.

En variante le sous-système multivoies à calibrer peut être la portion de l'antenne active 102 en mode réception, comprise entre la sortie 122 des sources de l'antenne Rx et l'entrée du module de formation de faisceaux 116 GBBF.

Suivant la Figure 6 et de manière générale, un système de calibration 202 d'un sous-système multivoies radiofréquence 204 d'une charge utile de télécommunications, comme par exemple ceux décrits dans les Figures 1 à 5, ayant un premier ensemble 206 de N voies d'accès en entrée et un deuxième ensemble 208 de M voies d'accès en sortie, comprend :
.- un premier dispositif 212 d'injection d'un signal de calibration analogique ou numérique en un point d'injection prédéterminé d'une voie d'accès d'entrée ou en plusieurs points d'injection prédéterminés associés chacun à une voie d'accès d'entrée différente ; et
.- un deuxième dispositif 214 de prélèvement du signal composite propagé, formé par le signal de calibration et le signal de trafic, en un point de prélèvement prédéterminé d'une voie d'accès de sortie ou en plusieurs points de prélèvement prédéterminés associés chacun à une voie d'accès de sortie différente ; et
.- un troisième dispositif 216 de génération du signal de calibration et de calcul numérique, formé d'un ou plusieurs calculateurs électroniques.

Suivant la Figure 6 et à titre d'exemple particulier, chaque voie d'accès en entrée comporte un point d'injection, réalisé ici par un coupleur ou un additionneur numérique, les points d'injection des trois voies d'accès en entrée illustrés sur la Figure 6 étant désignés par les références numériques 222, 224, 226. De même, chaque voie d'accès en sortie comporte un point de prélèvement du signal composite de calibration et de trafic, réalisé par exemple par un coupleur ou par un dispositif d'acquisition numérique, les points de prélèvement des trois voies d'accès en sortie illustrées ici sur la Figure 6 étant désignés par les références numériques 232, 234, 236.

Le troisième dispositif de génération du signal de calibration et de calcul numérique 216 est configuré pour :
.- générer un signal de calibration numérique correspondant à la version numérique ou analogique du signal de calibration injecté par le premier dispositif 212 ; et
.- extraire le signal de calibration à partir du ou des multiplexes de signaux de trafic et de signal de calibration prélevés en le point de prélèvement prédéterminé d'une voie d'accès de sortie ou en les points de prélèvement prédéterminés associés chacun à une voie d'accès de sortie différente et le signal de calibration généré ;
.- estimer des écarts d'amplitude et/ou de phase entre les voies internes du sous-système multivoies à partir du signal de calibration injecté en entrée servant de référence et du ou des signaux de calibration extraits ; et
.- définir des corrections pour réduire au maximum les écarts d'amplitude et/ou phase, puis les appliquer en commandant un ou plusieurs moyens de correction desdits écarts lorsqu'un ou plusieurs de desdits écarts dépassent un seuil prédéterminé ;

Suivant la Figure 7, un procédé de calibration 302 d'un sous-système multivoies radiofréquence d'une charge utile de télécommunications comporte un ensemble d'étapes.

Dans une première étape 304 de génération et d'injection, un signal de calibration est généré et injecté en un point d'injection prédéterminé d'une voie d'accès d'entrée ou en plusieurs points prédéterminés associés chacun à une voie d'accès d'entrée différente.

Puis dans une deuxième étape d'extraction 306, le signal de calibration injecté et propagé en un point de prélèvement prédéterminé d'une voie d'accès de sortie ou en plusieurs points de prélèvement prédéterminés associés chacun à une voie d'accès de sortie différente, est extrait.

Ensuite dans une troisième étape d'estimation 308, des écarts d'amplitude et/ou de phase entre les voies internes du sous-système multivoies sont estimés à partir du signal de calibration injecté en entrée servant de référence et du ou des signaux de calibration extraits.

Puis, dans une quatrième étape de correction 310, des écarts d'amplitude et/ou phase sont corrigés par un ou plusieurs moyens de correction desdits écarts lorsqu'un ou plusieurs de ces derniers dépassent un seuil prédéterminé.

Le système 202 et le procédé 302 de calibration sont caractérisés en ce que le signal de calibration injecté est un signal de type « CHIRP », composé d'un CHIRP ou d'une séquence d'au moins deux CHIRPs identiques.

De manière générale un CHIRP est un signal dans lequel la fréquence ou décroit de manière continue avec le temps.

De manière générale, le CHIRP d'un signal de calibration injecté de type « CHIRP » est un signal complexe s(t) de la forme *s*(*t*) *= a*(*t*)*.* exp{*j*. *φ*(*t*)} où *a*(*t*) ≥ 0 est une amplitude passe-bas dont l'évolution temporelle est lente par rapport aux oscillations de la phase *φ*(*t*).

Il est à remarquer que la quatrième étape 310 peut être exécutée directement à bord du satellite ou au sol.

Suivant un premier mode de réalisation, la première étape 304 consiste à générer et injecter un ou des signaux de calibration en un point d'injection prédéterminé d'une voie d'accès d'entrée ou en plusieurs points prédéterminés associés chacun à une voie d'accès d'entrée différente, les signaux de calibration injectés étant des signaux de type « CHIRP » de même largeur de bande centrés à une même fréquence centrale.

Suivant un deuxième mode de réalisation, la première étape 304 consiste à générer et injecter des signaux de calibration en un point d'injection prédéterminé d'une voie d'accès d'entrée ou en plusieurs points prédéterminés associés chacun à une voie d'accès d'entrée différente, les signaux de calibration injectés étant des signaux de type « CHIRP » de même largeur de bande centrés à des fréquences centrales différentes réparties régulièrement sur la bande de communication des porteuses de trafic.

Au cours de la troisième étape 308, le procédé d'estimation des écarts d'amplitude et/ou de phase entre les voies internes du sous-système multivoies à partir du signal de calibration injecté en entrée servant de référence et du ou des signaux prélevés en sortie utilise un algorithme de deuxième type fondé sur un filtrage adapté par corrélation.

Suivant la Figure 8 et de manière préférée, le signal de calibration injecté est un signal de type « CHIRP » linéaire complexe périodisé s(t) de la forme *s*(*t*) *= A.* exp{*j*. *φ*(*t*)}, la fréquence instantanée f(t), définie par les équations : $f \left(t\right) = \frac{1}{2 π} ∗ \frac{dφ \left(t\right)}{dt} = F 1 + \frac{F 2 - F 1}{Tchirp} ∗ t$, évoluant suivant une fonction périodique de type dent de scie 354 répétant suivant une période temporelle Tchirp un motif 356 de rampe de fréquence variant linéairement entre une première valeur de fréquence F1 et une deuxième valeur de fréquence F2.

La première valeur de fréquence F1 est égale à ${F}_{ce} - \frac{{BW}_{chirp}}{2}$ et la deuxième valeur de fréquence F2 est égale à ${F}_{ce} + \frac{{BW}_{chirp}}{2}$*, F_{CE}* désignant une fréquence centrale prédéterminée et *BW_{chirp}* désignant la largeur de bande du CHIRP.

Pour chaque point de prélèvement du signal de calibration, le prélèvement et le traitement du signal de calibration concerne une séquence d'un nombre prédéterminé Nacq de motifs consécutifs ou CHIRPs ayant chacun une forme de rampe fréquentielle. La période d'acquisition Tacq du signal de calibration est ainsi égale à Nacq*Tchirp.

Suivant la Figure 9, une évolution temporelle 372 de l'amplitude réelle 374 de s(t) d'un motif CHIRP d'un signal de calibration injecté de type « CHIRP » avant traitement correspond à un exemple typique du mode de réalisation préféré du signal de calibration injecté suivant l'invention décrit à la Figure 8 ;

Suivant la Figure 10, un exemple de spectre 392 d'un signal CHIRP ayant la forme d'évolution fréquentielle décrite dans la Figure 8 et une largeur de bande Bchirp égale à 500 kHz est illustré à une fréquence centrale après transposition Fce égale à 3.5 MHz. Le spectre 392 décrit la variation 394 de la densité spectrale de puissance du signal, exprimé en dBW/bande résolution de l'analyseur de spectre, en fonction de la fréquence exprimée en MHz.

En conséquence, grâce à la forme d'onde particulière de CHIRP utilisée par le signal de calibration, le positionnement fréquentiel du signal de calibration injecté de type « CHIRP » peut être indépendant du plan de fréquence des porteuses de trafic sans que cela n'affecte les performances de calibration en termes de précisions des écarts estimés des amplitude/phase inter-voies entre voies internes ni ne dégrade les performances de communications des porteuses de trafic.

Suivant la Figure 11 et une première configuration particulière de plan de fréquences 402 des porteuses de trafic, la quasi-totalité de la puissance du signal de calibration 394 est concentrée dans le lobe principal 404 dudit signal de calibration injecté de type « CHIRP », le lobe principal ayant une largeur de bande *BW_{chirp}* , étant inclus en totalité dans la bande d'une porteuse de trafic 412 et interférant avec cette porteuse de trafic 412 avec un niveau de puissance relatif pouvant être très bas, par exemple inférieur ou égal à -30 dB/BWchirp ou -30dB + 10log(BWchirp/Rs) dans la bande Rs du rythme symbole de la porteuse de trafic. Après extraction, le rapport signal à bruit du signal de calibration atteint un niveau suffisamment élevé, par exemple 26dB, permettant de garantir de bonnes performances de calibration, c'est-à-dire de réaliser des estimations précises des écarts amplitude/phase entre voies, par exemple d'obtenir des dispersions des écarts de l'ordre de 0,5 degrés en sigma phase et 0,04dB en sigma amplitude sans dégrader les performances de communication de la porteuse de trafic.

En variante et suivant une deuxième configuration particulière de plan de fréquences des porteuses de trafic, le spectre du signal de calibration injecté de type « CHIRP » comporte un lobe principal qui a une largeur de bande B_{chirp} et qui est inclus partiellement dans la bande d'une porteuse de trafic avec un niveau de puissance relatif adapté pour garantir de bonnes performances de calibration sans dégrader les performances de communication de la porteuse de trafic.

En variante et suivant une troisième configuration particulière de plan de fréquences des porteuses de trafic, le spectre du signal de calibration injecté de type CHIRP comporte un lobe principal qui a une largeur de bande B_{chirp} et qui est inclus en totalité dans une bande de garde des porteuses de trafic.

Suivant la Figure 12 et un exemple de plan de fréquences 422 d'une voie i de transmission, le trafic acheminé 424 est représenté par des contours en traits pointillés et comprend un ensemble de porteuses chargées 426, 428, 430, 432, 434, 436 de différentes occupations spectrales. Dans la bande utile de la voie i de transmission, le signal de calibration 438, représenté par des contours en trait plein est ici injecté séquentiellement à des instants différents le long de la bande spectrale de la voie à des intervalles de fréquences correspondants espacés régulièrement. De manière non planifiée vis-à-vis du plan de fréquence du trafic, le signal de calibration injecté peut tomber à l'intérieur ou à cheval ou à l'extérieur d'une porteuse chargée.

Suivant la Figure 13 et le mode préféré de l'invention décrit à la Figure 8, la troisième étape 308 dans laquelle les écarts d'amplitude ΔA et/ou de phase ΔPhi entre les voies internes du sous-système multivoies sont estimés à partir du signal de calibration injecté en entrée servant de référence et du ou des signaux prélevés en sortie, comprend des première, deuxième, et troisième sous-étapes 452, 454, 456.

Dans la première sous-étape 452, pour chaque voie interne le signal de calibration du signal de trafic est extrait par un filtrage adapté qui maximise le rapport signal sur bruit du signal de calibration et qui maximise une fonction de corrélation entre les échantillons du signal prélevé en sortie et les échantillons du signal de calibration comme réplique de référence.

Puis, dans la deuxième sous-étape 454 l'amplitude A et la phase Phi de chaque voie interne sont estimés à partir du maximum de corrélation donnant le gain complexe et retard de propagation du signal de calibration depuis son point d'injection numérique jusqu'en sortie du filtrage adapté.

Ensuite, dans la troisième sous-étape 456, les écarts ΔA/ ΔPhi des voies internes relativement à une voie de référence prédéterminée sont calculés à partir des amplitudes et phase estimés A/Phi de chaque voie interne.

Suivant la Figure 14, un signal de calibration mesuré, illustré par une première courbe 482, est extrait du signal de trafic dans la première sous-étape 452 de la troisième étape 308 par une technique de filtrage adapté, permettant de maximiser le rapport signal sur bruit du signal corrélé complexe C(t) entre les échantillons du signal de sortie prélevé Sp(t) et les échantillons du signal de calibration d'entrée E(t), C(t) étant exprimée par l'équation suivante : $C \left(t\right) = Sp \left(t\right) ⊗ E * \left(-t\right)$

Une deuxième courbe 484 illustre la corrélation maximisée en rapport signal sur bruit du signal corrélé complexe du signal de calibration de référence servant de réplique avec lui-même.

Une troisième courbe 486 illustre le bruit extrait par le filtrage adapté.

L'extraction du signal de calibration prélevé par un filtrage adapté permet une injection d'un signal de calibration à très bas niveau, par exemple -30dB relativement à la puissance du signal de trafic interférant la bande du signal de calibration, et d'extraire le signal CHIRP noyé dans la porteuse de trafic chargée, avec un maximum de gain de traitement, pour obtenir un rapport signal à bruit positif objectif du signal de calibration, garant de la précision d'estimation des erreurs.

Ce rapport signal à bruit objectif du signal de calibration dépend du niveau d'injection relativement à celui de la porteuse de trafic dans la bande du signal de calibration, des caractéristiques du signal CHIRP (bande et durée), du nombre d'acquisitions Nacq pour chaque voie permettant un moyennage temporel.

En même temps, le niveau d'injection du signal de calibration étant très bas, la transmission du signal de télécommunication sur la porteuse de trafic est intègre avec une dégradation de taux d'erreur bit TEB et de son rapport signal à bruit C/N dans la bande de la porteuse utile dans les précisions de mesures des appareils de mesures.

Il est à remarquer que l'injection d'un signal de calibration en un point d'injection peut être mise en œuvre sur une voie d'accès en entrée de la charge utile, en numérique via un ou des convertisseurs numériques/analogiques CNA (en anglais Digital to Analogue Converter DAC) d'un processeur numérique transparent DTP (en anglais Digital Transparent Processor) ou non transparent, en analogique par coupleur coaxial par exemple.

Il est à remarquer que le signal prélevé en un point de prélèvement et d'extraction du signal de propagation injecté et propagé est en réalité un signal composite incluant une partie ou la totalité d'une porteuse de trafic chargée et la totalité du signal de calibration, et que le prélèvement du signal numérique peut être mis en œuvre sur la voie d'accès en sortie de la charge utile, en numérique après la fonction démultiplexeur d'un processeur numérique transparent ou pas, ou en analogique par coupleur coaxial par exemple, puis numérisé par une chaîne d'acquisition qui peut être une chaine du processeur ou une chaîne additionnelle.

Il est à remarquer que dans les cas où une calibration est nécessaire sur une large bande de fréquence, par exemple 2GHz en bande Ku, les étapes d'injection du signal de calibration, d'extraction du signal de calibration, d'estimation des erreurs entre voies sont réalisées séquentiellement, en plaçant le signal de calibration séquentiellement à plusieurs positions fréquentielles dans la bande de fréquence ou de sous-bandes de fréquences du plan de fréquence des porteuses de trafic.

Le procédé et le système de calibration selon l'invention, décrits ci-dessus, permettent pour un sous-système multivoies d'une charge utile de télécommunications embarquée, de réaliser une calibration à bord du satellite pour garantir les performances dudit sous-système multivoies sur la durée de vie du satellite, en conditions opérationnelles sans interrompre le trafic de télécommunication, et sans contraintes opérationnelles sur le plan de fréquence des porteuses de trafic.

Peu de matériel supplémentaire est à insérer à bord du satellite, la liste de ce matériel comprenant : des coupleurs coaxiaux si pas prévus dans la charge utile, une matrice de commutateurs RF en mode émission Tx, un diviseur RF en mode réception Rx, une chaîne de conversion de fréquence par transposition (une pour une conversion RF/FI en mode émission Tx et une pour FI/RF en mode réception Rx) et un harnais RF. Le traitement numérique des signaux, l'estimation des erreurs et la définition des corrections peuvent être mises en œuvre à bord du satellite dans un équipement déjà existant pour la charge utile en fonction de l'architecture de cette dernière ou un équipement dédié à la seule fonction de calibration.

Le sous-système multivoies de la charge utile embarquée peut être une antenne active ou semi-active.

Le sous-système multivoies de la charge utile embarquée peut être un dispositif d'amplification multiport MPA par lequel des porteuses en réutilisation de fréquence sont transmises, en raison du fait que c'est le rapport signal à bruit du signal de calibration, et non pas le rapport du signal à bruit d'une porteuse de trafic, qui va piloter la bonne estimation des erreurs en amplitude et phase. En effet, sur un port de sortie du MPA où une porteuse de trafic et le signal de calibration interféré se recombinent, les fuites d'isolation agrégées des autres porteuses de trafic co-fréquence vont être de second ordre par rapport à la puissance de la porteuse interférant le signal de calibration. Dans ce cas, le système de calibration ne requiert qu'un convertisseur analogique-numérique CAN pour numériser le signal composite par point de prélèvement en sortie du sous-système multivoies, puisque le signal de calibration numérique de référence est généré à bord et qu'il n'y a pas besoin de l'acquérir en parallèle de l'acquisition du signal de prélèvement en sortie.

En variante, le procédé et le système de calibration selon l'invention, décrits ci-dessus, permettent pour un sous-système multivoies d'une charge utile de télécommunications, formant une antenne active en mode émission Tx ou en mode réception Rx avec formation de faisceaux au sol GBBF, et distribuée sur un satellite et une station sol, de réaliser une calibration distribuée sur le satellite et la station sol pour garantir les performances dudit sous-système multivoies sur la durée de vie du satellite, en conditions opérationnelles sans interrompre le trafic de télécommunications, et sans contraintes opérationnelles sur le plan de fréquence des porteuses de trafic.

Il est à remarquer que le procédé de calibration et le système de calibration peuvent être limités dans leur utilisation à une simple surveillance du sous-système multivoies, sans application de corrections.

Il est à remarquer que le procédé de calibration et le système de calibration peut servir également à l'alignement des voies des sous-systèmes multivoies en phase d'assemblage, d'intégration et de test AIT (en anglais Assembly, Integration and Test).

## Revendications

1. Procédé de calibration d'un sous-système multivoies radiofréquence (12 ; 32 ; 52 ; 72 ; 102 ; 204) d'une charge utile de télécommunications, la charge utile étant incluse en totalité dans et embarquée à bord d'un satellite ou distribuée sur un satellite et une station sol de formation de faisceaux, la calibration ayant lieu pendant que la charge utile est en opération,
le sous-système multivoies (12 ; 32 ; 52 ; 72 ; 102 ; 204) comprenant :
.- un premier nombre entier N, supérieur ou égal à 2, de voies d'accès en entrée, et
.- un deuxième nombre entier M, supérieur ou égal à 1, de voies d'accès en sortie, et
.- un ensemble (26 ; 46 ; 66 ; 96 ; 126) d'au moins deux voies internes, formées chacune d'une chaine de composants radiofréquence de même architecture, soit distribuant un même signal d'entrée fourni par une voie d'accès en entrée sur plusieurs voies d'accès en sortie, soit concentrant plusieurs signaux d'entrée fournis respectivement par plusieurs voies d'accès en entrée sur une même voie d'accès en sortie,
le procédé de calibration comportant :
.- une première étape (304) de génération et d'injection d'un signal de calibration en un point d'injection prédéterminé d'une voie d'accès d'entrée ou en plusieurs points prédéterminés associés chacun à une voie d'accès d'entrée différente, puis
.- une deuxième étape (306) d'extraction du signal de calibration injecté et propagé en un point de prélèvement prédéterminé d'une voie d'accès de sortie ou en plusieurs points de prélèvement prédéterminés associés chacun à une voie d'accès de sortie différente, puis
.- une troisième étape (308) d'estimation des écarts d'amplitude et/ou de phase entre les voies internes du sous-système multivoies à partir du signal de calibration injecté en entrée servant de référence et du ou des signaux de calibration extraits ; puis
.- une quatrième étape (310) de correction des écarts d'amplitude et/ou phase par un ou plusieurs moyens de correction desdits écarts lorsqu'un ou plusieurs de ces derniers dépassent un seuil prédéterminé ;
le procédé de calibration étant **caractérisé en ce que** :
le signal de calibration injecté est un signal de type « CHIRP », composé d'un ou plusieurs mêmes motifs CHIRP dans lequel la fréquence varie linéairement dans une bande de fréquence donnée (BW_{chirp}), **en ce que** le signal de calibration est injecté à un niveau de puissance suffisamment faible pour ne pas dégrader les performances de signaux de trafic transmis sur les voies d'accès, et **en ce que** la deuxième étape (306) d'extraction du signal de calibration comprend le filtrage du ou des signaux prélevés en un ou plusieurs points de sortie par un filtre adapté au signal de calibration.

2. Procédé de calibration d'un sous-système multivoies radiofréquence selon la revendication 1, dans lequel chaque motif CHIRP du signal de calibration injecté de type « CHIRP » est un signal complexe s(t) de la forme *s*(*t*) *= a*(*t*)*.* exp{*j*. *φ*(*t*)} où *a*(*t*) ≥ 0 est une amplitude passe-bas dont l'évolution temporelle est lente par rapport aux oscillations de la phase *φ*(*t*).

3. Procédé de calibration d'un sous-système multivoies radiofréquence selon l'une quelconque des revendications 1 et 2, dans lequel le signal de calibration injecté est un signal de type « CHIRP » linéaire complexe périodisé s(t) de la forme *s*(*t*) = *A.* exp(*j. φ*(*t*)}, la fréquence instantanée : $f \left(t\right) = \frac{1}{2 π} ∗ \frac{d φ \left(t\right)}{dt} = F 1 + \frac{F 2 - F 1}{T 1} ∗ t$
évoluant suivant une fonction périodique de type dent de scie répétant suivant une période temporelle T1 un motif de rampe de fréquence variant linéairement entre une première valeur de fréquence F1 et une deuxième valeur de fréquence F2,
La première valeur de fréquence F1 étant égale à ${F}_{ce} - \frac{B {W}_{chirp}}{2}$ et la deuxième valeur de fréquence F2 étant égale à ${F}_{ce} + \frac{B {W}_{chirp}}{2}$*, F_{ce}* désignant une fréquence centrale prédéterminée et *BW_{chirp}* désignant la largeur de bande du CHIRP.

4. Procédé de calibration d'un sous-système multivoies radiofréquence selon l'une quelconque des revendications 1 à 3 dans lequel le positionnement fréquentiel du signal de calibration injecté de type « CHIRP » est indépendant du plan de fréquence (402) des porteuses de trafic.

5. Procédé de calibration d'un sous-système multivoies radiofréquence selon l'une quelconque des revendications 1 à 4, dans lequel le spectre du signal de calibration injecté de type « CHIRP » comporte un lobe principal qui a une largeur de bande *B_{chirp}* et qui est inclus en totalité dans la bande d'une porteuse de trafic.

6. Procédé de calibration d'un sous-système multivoies radiofréquence selon l'une quelconque des revendications 1 à 4, dans lequel le spectre du signal de calibration injecté de type « CHIRP » comporte un lobe principal qui a une largeur de bande *B_{chirp}* et qui est inclus partiellement dans la bande d'une porteuse de trafic.

7. Procédé de calibration d'un sous-système multivoies radiofréquence selon l'une des revendications 1 à 4, dans lequel le spectre du signal de calibration injecté de type « CHIRP » comporte un lobe principal qui a une largeur de bande *B_{chirp}* et qui est inclus en totalité dans une bande de garde des porteuses de trafic.

8. Procédé de calibration d'un sous-système multivoies radiofréquence selon l'une quelconque des revendications 1 à 7, dans lequel
la première étape (304) consiste à générer et injecter des signaux de calibration en un point d'injection prédéterminé d'une voie d'accès d'entrée ou en plusieurs points prédéterminés associés chacun à une voie d'accès d'entrée différente, et
les signaux de calibration injectés sont des signaux de type « CHIRP » de même largeur de bande centrés à des fréquences centrales différentes réparties régulièrement sur la bande de communication des porteuses de trafic.

9. Procédé de calibration d'un sous-système multivoies radiofréquence selon l'une quelconque des revendications 1 à 8, dans lequel :
le signal de calibration injecté est un signal de type « CHIRP » linéaire complexe périodisé s(t) de la forme *s*(*t*) *= A.* exp{*j*. *φ*(*t*)}
la fréquence instantanée f(t), exprimée par les équations : $f \left(t\right) = \frac{1}{2 π} ∗ \frac{d φ \left(t\right)}{dt} = F 1 + \frac{F 2 - F 1}{T 1} ∗ t$
évoluant suivant une fonction périodique de type dent de scie répétant suivant une période temporelle T1 un motif de rampe de fréquence variant linéairement entre une première valeur de fréquence F1 et une deuxième valeur de fréquence F2,
la première valeur de fréquence F1 étant égale à ${F}_{ce} - \frac{B {W}_{chirp}}{2}$ et la deuxième valeur de fréquence F2 étant égale à ${F}_{ce} + \frac{B {W}_{chirp}}{2}$*, F_{ce}* désignant une fréquence centrale prédéterminée et *BW_{chirp}* désignant la largeur de bande du CHIRP ; et
au cours de la troisième étape (308), les écarts d'amplitude Δ*A* et/ou de phase Δ*Phi* entre les voies internes du sous-système multivoies sont estimés à partir du signal de calibration injecté en entrée servant de référence et du ou des signaux prélevées en sortie,
en extrayant (452) pour chaque voie interne le signal de calibration du signal de trafic par un filtrage adapté qui maximise le rapport signal sur bruit du signal de calibration et qui maximise une fonction de corrélation entre les échantillons du signal prélevé en sortie et les échantillons du signal de calibration comme réplique de référence, et
en estimant (454) l'amplitude A et la phase Phi de chaque voie interne à partir du maximum de corrélation donnant le gain complexe et retard de propagation du signal de calibration depuis son point d'injection numérique jusqu'en sortie du filtrage adapté ; puis
en calculant (456) les écarts Δ*A*l Δ*Phi* des voies internes relativement à une voie de référence prédéterminée à partir des amplitude et phase estimés A/Phi de chaque voie.

10. Procédé de calibration d'un sous-système multivoies radiofréquence selon l'une quelconque des revendications 1 à 8, dans lequel :
lorsque la charge utile de télécommunication est incluse en totalité dans et embarquée à bord d'un satellite, le système multivoies radiofréquence est
un MPA comportant deux matrices de Butler, avec la matrice de Butler d'entrée numérique ou analogique, sans réseau de formation de faisceaux BFN, intégré dans une antenne active ou pas ; ou
un MPA avec un réseau de formation de faisceaux BFN en entrée numérique ou analogique et une matrice de Butler en sortie, intégré au sein d'une antenne active ou pas ; ou
un amplificateur multiport parallélisé MPPA comportant des amplificateurs parallélisés à l'intérieur d'un MPA, intégré au sein d'une antenne active ou pas ; ou
une antenne semi-active dite « Multimatrix » avec réflecteur, avec ou sans MPA ; ou
une antenne active de type réseau à rayonnement direct DRA ou une antenne à sous-réflecteur alimenté par un réseau de sources AFSRA ou une antenne à réflecteur alimenté en son point focal par un réseau de sources FAFR avec un BFN analogique ou numérique ; ou
une fonction à bord nécessitant l'appairage en amplitude/phase de plusieurs voies entre elles ;
et
lorsque la charge utile de télécommunication est distribuée sur un satellite et une station sol de formation de faisceaux, le système multivoies radiofréquence est
une antenne active satellitaire en mode réception Rx avec formation effective de faisceaux au sol GBBF; ou
une antenne active satellitaire en mode émission Tx avec formation effective de faisceaux au sol GBBF, avec ou sans une fonction MPA ou MPPA entièrement à bord ou avec ou sans une fonction MPA ou MPPA dont la matrice de Butler d'entrée est distribuée au sol.

11. Procédé de calibration d'un sous-système multivoies radiofréquence selon l'une quelconque des revendications 1 à 10 dans lequel :
la quatrième étape (310) est exécutée directement à bord du satellite ou au sol.

12. Système de calibration d'un sous-système multivoies radiofréquence (12 ; 32 ; 52 ; 72 ; 102 ; 204) d'une charge utile de télécommunications, la charge utile étant incluse en totalité dans et embarquée à bord d'un satellite ou distribuée sur un satellite et une station sol de formation de faisceaux, la calibration ayant lieu pendant que la charge utile est en opération,
le sous-système multivoies (12 ; 32 ; 52 ; 72 ; 102 ; 204) comprenant :
.- un premier nombre entier N, supérieur ou égal à 2, de voies d'accès en entrée, et
.- un deuxième nombre entier M, supérieur ou égal à 2, de voies d'accès en sortie, et
.- un ensemble (26 ; 46 ; 66 ; 96 ; 126) d'au moins deux voies internes, formées chacune d'une chaine de composants radiofréquence de même architecture, soit distribuant un même signal d'entrée fourni par une voie d'accès en entrée sur plusieurs voies d'accès en sortie, soit concentrant plusieurs signaux d'entrée fournis respectivement par plusieurs voies d'accès en entrée sur une même voie d'accès en sortie ; et
Le système de calibration comprenant
un premier dispositif (212) d'injection d'un signal de calibration analogique ou numérique en un point d'injection prédéterminé d'une voie d'accès d'entrée ou en plusieurs points prédéterminés associés chacun à une voie d'accès d'entrée différente ; et
un deuxième dispositif (214) de prélèvement du signal de calibration injecté et propagé en un point de prélèvement prédéterminé d'une voie d'accès de sortie ou en plusieurs points de prélèvement prédéterminés associés chacun à une voie d'accès de sortie différente ;
un troisième dispositif (216) de calcul numérique, formé d'un ou plusieurs calculateurs électroniques, et configuré pour :
.- générer un signal de calibration numérique correspondant à la version numérique ou analogique du signal de calibration injecté par le premier dispositif ; et
.- extraire le signal de calibration injecté à partir du ou des signaux prélevés en le point de prélèvement prédéterminé d'une voie d'accès de sortie ou en les points de prélèvement prédéterminés associés chacun à une voie d'accès de sortie différente et du signal de calibration généré ;
.- estimer des écarts d'amplitude et/ou de phase entre les voies internes du sous-système multivoies à partir du signal de calibration injecté en entrée servant de référence et du ou des signaux de calibration extraits ; et
.- corriger des écarts d'amplitude et/ou phase en commandant un ou plusieurs moyens de correction desdits écarts lorsqu'un ou plusieurs de desdits écarts dépassent un seuil prédéterminé ;
le système de calibration étant **caractérisé en ce que** le signal de calibration injecté est un signal de type « CHIRP », composé d'un ou plusieurs mêmes motifs CHIRP dans lequel la fréquence varie linéairement dans une bande de fréquence donnée (BW_{chirp}), **en ce que** le signal de calibration est injecté à un niveau de puissance suffisamment faible pour ne pas dégrader les performances de signaux de trafic transmis sur les voies d'accès, et **en ce que** l'extraction du signal de calibration comprend le filtrage du ou des signaux prélevés en un ou plusieurs points de sortie par un filtre adapté au signal de calibration.

13. Système de calibration d'un sous-système multivoies radiofréquence selon la revendication 12 dans lequel
le signal de calibration injecté est un signal de type « CHIRP » linéaire complexe périodisé s(t) de la forme *s*(*t*) *= A.* exp{*j*. *φ*(*t*)},
la fréquence instantanée f(t), définie par les équations : $f \left(t\right) = \frac{1}{2 π} ∗ \frac{d φ \left(t\right)}{dt} = F 1 + \frac{F 2 - F 1}{T 1} ∗ t ,$
évoluant suivant une fonction périodique de type dent de scie répétant suivant une période temporelle T1 un motif de rampe de fréquence variant linéairement entre une première valeur de fréquence F1 et une deuxième valeur de fréquence F2,
la première valeur de fréquence F1 étant égale à ${F}_{ce} - \frac{B {W}_{chirp}}{2}$ et la deuxième valeur de fréquence F2 étant égale à ${F}_{ce} + \frac{B {W}_{chirp}}{2}$, *F_{ce}* désignant une fréquence centrale prédéterminée et *BW_{chirp}* désignant la largeur de bande du CHIRP ; et
le positionnement fréquentiel du signal de calibration injecté de type CHIRP est indépendant du plan de fréquence des porteuses de trafic.

14. Système de calibration d'un sous-système multivoies radiofréquence selon l'une quelconque des revendications 12 à 13 dans lequel :
les premier et deuxième dispositifs (212 ; 214) sont configurés pour générer et injecter des signaux de calibration en un point d'injection prédéterminé d'une voie d'accès d'entrée ou en plusieurs points prédéterminés associés chacun à une voie d'accès d'entrée différente, et
les signaux de calibration injectés sont des signaux de type « CHIRP » de même largeur de bande centrés à des fréquences centrales différentes réparties régulièrement sur la bande de communication des porteuses de trafic.

15. Système de calibration d'un sous-système multivoies radiofréquence selon l'une quelconque des revendications 12 à 14 dans lequel :
lorsque la charge utile de télécommunication est incluse en totalité dans et embarquée à bord d'un satellite, le système multivoies radiofréquence est
un MPA comportant deux matrices de Butler, avec la matrice de Butler d'entrée numérique ou analogique, sans réseau de formation de faisceaux BFN, intégré au sein d'une antenne active ou pas ; ou
un MPA avec un réseau de formation de faisceaux BFN en entrée numérique ou analogique et une matrice de Butler en sortie, intégré au sein d'une antenne active ou pas ; ou
un amplificateur multiport parallélisé MPPA comportant des amplificateurs parallélisés à l'intérieur d'un MPA, intégré au sein d'une antenne active ou pas ; ou
une antenne semi-active dite « Multimatrix » avec réflecteur, avec ou sans MPA ; ou
une antenne active de type réseau à rayonnement direct DRA ou une antenne à sous-réflecteur alimenté par un réseau de sources AFSRA ou une antenne à réflecteur alimenté en son point focal par un réseau de sources FAFR avec un BFN analogique ou numérique ; ou
une fonction à bord nécessitant l'appairage en amplitude/phase de plusieurs voies entre elles ;
et
lorsque la charge utile de télécommunication est distribuée sur un satellite et une station sol de formation de faisceaux, le système multivoies radiofréquence est
une antenne active satellitaire en mode réception Rx avec formation effective de faisceaux au sol GBBF, ou
une antenne active satellitaire en mode émission Tx avec formation effective de faisceaux au sol GBBF, avec ou sans une fonction MPA ou MPPA entièrement à bord ou avec ou sans une fonction MPA ou MPPA dont la matrice de Butler d'entrée est distribuée au sol.

## Patentansprüche

1. Verfahren zur Kalibrierung eines Hochfrequenz-Mehrkanal-Subsystems (12; 32; 52; 72; 102; 204) einer Telekommunikationsnutzlast, wobei die Nutzlast vollständig in einem Satelliten enthalten und an Bord desselben untergebracht oder auf einen Satelliten und eine Strahlformungs-Bodenstation verteilt ist, wobei die Kalibrierung stattfindet, während sich die Nutzlast in Betrieb befindet,
wobei das Mehrkanal-Subsystem (12; 32; 52; 72; 102; 204) umfasst:
.- eine erste ganze Zahl N, größer oder gleich 2, von Zugriffskanälen am Eingang, und
.- eine zweite ganze Zahl M, größer oder gleich 1, von Zugriffskanälen am Ausgang, und
.- eine Anordnung (26; 46; 66; 96; 126) von mindestens zwei internen Kanälen, die jeweils aus einer Kette von Hochfrequenzkomponenten gleicher Architektur gebildet sind und entweder dasselbe Eingangssignal, das von einem Zugriffskanal am Eingang geliefert wird, auf mehrere Zugriffskanäle am Ausgang verteilen oder mehrere Eingangssignale, die jeweils von mehreren Zugriffskanälen am Eingang geliefert werden, auf denselben Zugriffskanal am Ausgang bündeln,
wobei das Kalibrierungsverfahren umfasst:
.- einen ersten Schritt (304) des Erzeugens eines Kalibrierungssignals und Einspeisens an einem vorbestimmten Einspeisepunkt eines Eingangszugriffskanals oder an mehreren vorbestimmten Punkten, die jeweils einem anderen Eingangszugriffskanal zugeordnet sind, und anschließend
.- einen zweiten Schritt (306) des Extrahierens des eingespeisten und weitergeleiteten Kalibrierungssignals an einem vorbestimmten Abgriffspunkt eines Ausgangszugriffskanals oder an mehreren vorbestimmten Abgriffspunkten, die jeweils einem anderen Ausgangszugriffskanal zugeordnet sind, und anschließend
.- einen dritten Schritt (308) des Schätzens der Amplituden- und/oder Phasenabweichungen zwischen den internen Kanälen des Mehrkanal-Subsystems auf Grundlage des am Eingang eingespeisten Kalibrierungssignals, das als Referenz dient, und des oder der extrahierten Kalibrierungssignale; und anschließend
.- einen vierten Schritt (310) des Korrigierens der Amplituden- und/oder Phasenabweichungen durch ein oder mehrere Mittel zur Korrektur der Abweichungen, wenn eine oder mehrere davon eine vorbestimmte Schwelle überschreiten;
das Kalibrierungsverfahren **dadurch gekennzeichnet, dass**:
das eingespeiste Kalibrierungssignal ein Signal vom Typ "CHIRP" ist, das aus einem oder mehreren gleichen CHIRP-Mustern zusammengesetzt ist, wobei die Frequenz in einem gegebenen Frequenzband ( *BW_{chirp}* ) linear variiert, dass das Kalibrierungssignal mit einem Leistungspegel eingespeist wird, der ausreichend niedrig ist, um die Leistung von Verkehrssignalen, die über die Zugriffskanäle übertragen werden, nicht zu beeinträchtigen, und dass der zweite Schritt (306) des Extrahierens des Kalibrierungssignals das Filtern des oder der an einem oder mehreren Ausgangspunkten abgegriffenen Signale durch ein für das Kalibrierungssignal geeignetes Filter umfasst.

2. Verfahren zur Kalibrierung eines Hochfrequenz-Mehrkanal-Subsystems nach Anspruch 1, wobei jedes CHIRP-Muster des eingespeisten Kalibrierungssignals vom Typ "CHIRP" ein komplexes Signal s(t) der Form *s*(*t*) *= a*(*t*)*.* exp {*j. φ*(*t*)} ist, wobei *a*(*t*) ≥ 0 eine Tiefpassamplitude ist, deren zeitlicher Verlauf in Bezug auf die Schwingungen der Phase *φ*(*t*) langsam ist.

3. Verfahren zur Kalibrierung eines Hochfrequenz-Mehrkanal-Subsystems nach einem der Ansprüche 1 und 2, wobei das eingespeiste Kalibrierungssignal ein periodisiertes, komplexes, lineares Signal vom Typ "CHIRP" s(t) der Form *s*(*t*) = *A ·* exp {*j · φ*(*t*)} ist, wobei die momentane Frequenz: $f \left(t\right) = \frac{1}{2 π} ∗ \frac{dφ \left(t\right)}{dt} = F 1 + \frac{F 2 - F 1}{T 1} ∗ t$
gemäß einer periodischen Funktion vom Sägezahntyp verläuft, die gemäß einer Zeitperiode T1 ein Frequenzrampenmuster wiederholt, das linear zwischen einem ersten Frequenzwert F1 und einem zweiten Frequenzwert F2 variiert,
wobei der erste Frequenzwert F1 gleich ${F}_{ce} - \frac{{BW}_{chirp}}{2}$ ist und der zweite Frequenzwert F2 gleich ${F}_{ce} + \frac{{BW}_{chirp}}{2}$, *F_{ce}* eine vorbestimmte Mittenfrequenz bezeichnet und *BW_{chirp}* die Bandbreite des CHIRP bezeichnet.

4. Verfahren zur Kalibrierung eines Hochfrequenz-Mehrkanal-Subsystems nach einem der Ansprüche 1 bis 3, wobei die Frequenzpositionierung des eingespeisten Kalibrierungssignals vom Typ "CHIRP" von der Frequenzebene (402) der Verkehrsträger unabhängig ist.

5. Verfahren zur Kalibrierung eines Hochfrequenz-Mehrkanal-Subsystems nach einem der Ansprüche 1 bis 4, wobei das Spektrum des eingespeisten Kalibrierungssignals vom Typ "CHIRP" eine Hauptkeule umfasst, die eine Bandbreite *B_{chirp}* aufweist und die vollständig in dem Band eines Verkehrsträgers enthalten ist.

6. Verfahren zur Kalibrierung eines Hochfrequenz-Mehrkanal-Subsystems nach einem der Ansprüche 1 bis 4, wobei das Spektrum des eingespeisten Kalibrierungssignals vom Typ "CHIRP" eine Hauptkeule umfasst, die eine Bandbreite *B_{chirp}* aufweist und die teilweise in dem Band eines Verkehrsträgers enthalten ist.

7. Verfahren zur Kalibrierung eines Hochfrequenz-Mehrkanal-Subsystems nach einem der Ansprüche 1 bis 4, wobei das Spektrum des eingespeisten Kalibrierungssignals vom Typ "CHIRP" eine Hauptkeule umfasst, die eine Bandbreite *B_{chirp}* aufweist und die vollständig in einem Schutzband der Verkehrsträger enthalten ist.

8. Verfahren zur Kalibrierung eines Hochfrequenz-Mehrkanal-Subsystems nach einem der Ansprüche 1 bis 7, wobei
der erste Schritt (304) darin besteht, Kalibrierungssignale zu erzeugen und an einem vorbestimmten Einspeisepunkt eines Eingangszugriffskanals oder an mehreren vorbestimmten Punkten, die jeweils einem anderen Eingangszugriffskanal zugeordnet sind, einzuspeisen, und
die eingespeisten Kalibrierungssignale Signale vom Typ "CHIRP" gleicher Bandbreite sind, die auf unterschiedliche Mittenfrequenzen zentriert sind und die gleichmäßig über das Kommunikationsband der Verkehrsträger verteilt sind.

9. Verfahren zur Kalibrierung eines Hochfrequenz-Mehrkanal-Subsystems nach einem der Ansprüche 1 bis 8, wobei:
das eingespeiste Kalibrierungssignal ein periodisiertes komplexes lineares Signal vom Typ "CHIRP" s(t) der Form *s*(*t*) = *A ·* exp {*j · φ*(*t*)} ist,
die momentane Frequenz f(t), ausgedrückt durch die Gleichungen: $f \left(t\right) = \frac{1}{2 π} ∗ \frac{dφ \left(t\right)}{dt} = F 1 + \frac{F 2 - F 1}{T 1} ∗ t$
gemäß einer periodischen Funktion vom Sägezahntyp verläuft, die gemäß einer Zeitperiode T1 ein Frequenzrampenmuster wiederholt, das linear zwischen einem ersten Frequenzwert F1 und einem zweiten Frequenzwert F2 variiert,
der erste Frequenzwert F1 gleich ${F}_{ce} - \frac{{BW}_{chirp}}{2}$ ist und der zweite Frequenzwert F2 gleich ${F}_{ce} + \frac{{BW}_{chirp}}{2}$ , *F_{ce}* eine vorbestimmte Mittenfrequenz bezeichnet und *BW_{chirp}* die Bandbreite des CHIRP bezeichnet; und
im dritten Schritt (308) die Amplitudenabweichungen Δ*A* und/oder Phasenabweichungen *ΔPhi* zwischen den internen Kanälen des Mehrkanal-Subsystems auf Grundlage des am Eingang eingespeisten Kalibrierungssignals, das als Referenz dient, und des oder der am Ausgang abgegriffenen Signale geschätzt werden,
durch Extrahieren (452), für jeden internen Kanal, des Kalibrierungssignals aus dem Verkehrssignal durch eine geeignete Filterung, die das Signal-Rausch-Verhältnis des Kalibrierungssignals maximiert und die eine Korrelationsfunktion zwischen den Abtastwerten des am Ausgang abgegriffenen Signals und den Abtastwerten des Kalibrierungssignals als Nachbildung der Referenz maximiert, und
durch Schätzen (454) der Amplitude A und der Phase Phi jedes internen Kanals auf Grundlage des Korrelationsmaximums, was die komplexe Verstärkung und die Laufzeit des Kalibrierungssignals von dessen digitalen Einspeisepunkt bis zum Ausgang der geeigneten Filterung ergibt; und anschließend
durch Berechnen (456) der Abweichungen Δ*A*/Δ*Phi* der internen Kanäle relativ zu einem vorbestimmten Referenzkanal auf Grundlage der geschätzten Amplitude und Phase A/Phi jedes Kanals.

10. Verfahren zur Kalibrierung eines Hochfrequenz-Mehrkanal-Subsystems nach einem der Ansprüche 1 bis 8, wobei:
wenn die Telekommunikationsnutzlast vollständig in einem Satelliten enthalten und an Bord desselben untergebracht ist, das Hochfrequenz-Mehrkanalsystem Folgendes ist
ein MPA, der zwei Butler-Matrizen umfasst, wobei die digitale oder analoge Butler-Eingangsmatrix, ohne Strahlformungsnetzwerk, BFN, in eine aktive Antenne integriert ist oder nicht; oder
ein MPA mit einem Strahlformungsnetzwerk, BFN, am digitalen oder analogen Eingang und einer Butler-Matrix am Ausgang, der in eine aktive Antenne integriert ist oder nicht; oder
ein parallelgeschalteter Mehrportverstärker, MPPA, der parallelgeschaltete Verstärker innerhalb einer MPA umfasst, in eine aktive Antenne integriert oder nicht; oder
eine halbaktive, sogenannte "Multimatrix"-Antenne mit Reflektor, mit oder ohne MPA; oder
eine aktive Antenne vom Typ Direct Radiation Array, DRA, oder eine Antenne mit einem von einem Quellenarray gespeisten Subreflektor, AFSRA, oder eine Antenne mit an seinem Brennpunkt von einem Quellenarray gespeisten Reflektor, FAFR, mit einem analogen oder digitalen BFN; oder
eine bordseitige Funktion, die die Amplituden-/Phasenkopplung mehrerer Kanäle untereinander erfordert;
und
wenn die Telekommunikationsnutzlast auf einen Satelliten und eine Strahlformungs-Bodenstation verteilt ist, das Hochfrequenz-Mehrkanalsystem Folgendes ist
eine aktive Satellitenantenne im Empfangsmodus, Rx, mit effektiver Strahlformung am Boden, GBBF; oder
eine aktive Satellitenantenne im Sendemodus, Tx, mit effektiver Strahlformung am Boden, GBBF, mit oder ohne vollständig an Bord befindlicher MPA- oder MPPA-Funktion oder mit oder ohne MPA- oder MPPA-Funktion, deren Butler-Eingangsmatrix am Boden verteilt ist.

11. Verfahren zur Kalibrierung eines Hochfrequenz-Mehrkanal-Subsystems nach einem der Ansprüche 1 bis 10, wobei:
der vierte Schritt (310) direkt an Bord des Satelliten oder am Boden ausgeführt wird.

12. System zur Kalibrierung eines Hochfrequenz-Mehrkanal-Subsystems (12; 32; 52; 72; 102; 204) einer Telekommunikationsnutzlast, wobei die Nutzlast vollständig in einem Satelliten enthalten und an Bord desselben untergebracht oder auf einen Satelliten und eine Strahlformungs-Bodenstation verteilt ist, wobei die Kalibrierung stattfindet, während sich die Nutzlast in Betrieb befindet,
wobei das Mehrkanal-Subsystem (12; 32; 52; 72; 102; 204) umfasst:
.- eine erste ganze Zahl N, größer oder gleich 2, von Zugriffskanälen am Eingang, und
.- eine zweite ganze Zahl M, größer oder gleich 2, von Zugriffskanälen am Ausgang, und
.- eine Anordnung (26; 46; 66; 96; 126) von mindestens zwei internen Kanälen, die jeweils aus einer Kette von Hochfrequenzkomponenten gleicher Architektur gebildet sind und entweder dasselbe Eingangssignal, das von einem Zugriffskanal am Eingang geliefert wird, auf mehrere Zugriffskanäle am Ausgang verteilen oder mehrere Eingangssignale, die jeweils von mehreren Zugriffskanälen am Eingang geliefert werden, auf denselben Zugriffskanal am Ausgang bündeln; und
wobei das Kalibrierungssystem umfasst
eine erste Vorrichtung (212) zum Einspeisen eines analogen oder digitalen Kalibrierungssignals an einem vorbestimmten Einspeisepunkt eines Eingangszugriffskanals oder an mehreren vorbestimmten Punkten, die jeweils einem anderen Eingangszugriffskanal zugeordnet sind; und
eine zweite Vorrichtung (214) zum Abgreifen des eingespeisten und weitergeleiteten Kalibrierungssignals an einem vorbestimmten Abgriffspunkt eines Ausgangszugriffskanals oder an mehreren vorbestimmten Abgriffspunkten, die jeweils einem anderen Ausgangszugriffskanal zugeordnet sind;
eine dritte digitale Rechenvorrichtung (216), die von einem oder mehreren elektronischen Rechnern gebildet wird und so konfiguriert ist, dass sie:
. ein digitales Kalibrierungssignal erzeugt, das der digitalen oder analogen Version des von der ersten Vorrichtung eingespeisten Kalibrierungssignals entspricht; und
. das eingespeiste Kalibrierungssignal auf Grundlage des oder der an dem vorbestimmten Abgriffspunkt eines Ausgangszugriffskanals oder an den vorbestimmten Abgriffspunkten, die jeweils einem anderen Ausgangszugriffskanal zugeordnet sind, abgegriffenen Signale und des erzeugten Kalibrierungssignals extrahiert;
.- Amplituden- und/oder Phasenabweichungen zwischen den internen Kanälen des Mehrkanal-Subsystems auf Grundlage des am Eingang eingespeisten Kalibrierungssignals, das als Referenz dient, und des oder der extrahierten Kalibrierungssignale schätzt; und
.- Amplituden- und/oder Phasenabweichungen durch Steuern eines oder mehrerer Mittel zur Korrektur der Abweichungen korrigiert, wenn eine oder mehrere der Abweichungen eine vorbestimmte Schwelle überschreiten;
das Kalibrierungssystem **dadurch gekennzeichnet, dass** das eingespeiste Kalibrierungssignal ein Signal vom Typ "CHIRP" ist, das aus einem oder mehreren gleichen CHIRP-Mustern zusammengesetzt ist, wobei die Frequenz in einem gegebenen Frequenzband ( BW_{chirp} ) linear variiert, dass das Kalibrierungssignal mit einem Leistungspegel eingespeist wird, der ausreichend niedrig ist, um die Leistung von Verkehrssignalen, die über die Zugriffskanäle übertragen werden, nicht zu beeinträchtigen, und dass das Extrahieren des Kalibrierungssignals das Filtern des oder der an einem oder mehreren Ausgangspunkten abgegriffenen Signale durch ein für das Kalibrierungssignal geeignetes Filter umfasst.

13. System zur Kalibrierung eines Hochfrequenz-Mehrkanal-Subsystems nach Anspruch 12, wobei:
das eingespeiste Kalibrierungssignal ein periodisiertes komplexes lineares Signal vom Typ "CHIRP" s(t) der Form *s*(*t*) = *A*. exp {*j. φ*(*t*)} ist,
die momentane Frequenz f(t), definiert durch die Gleichungen: $f \left(t\right) = \frac{1}{2 π} ∗ \frac{dφ \left(t\right)}{dt} = F 1 + \frac{F 2 - F 1}{T 1} ∗ t ,$
gemäß einer periodischen Funktion vom Sägezahntyp verläuft, die gemäß einer Zeitperiode T1 ein Frequenzrampenmuster wiederholt, das linear zwischen einem ersten Frequenzwert F1 und einem zweiten Frequenzwert F2 variiert,
der erste Frequenzwert F1 gleich ${F}_{ce} - \frac{{BW}_{chirp}}{2}$ ist und der zweite Frequenzwert F2 gleich ${F}_{ce} + \frac{{BW}_{chirp}}{2}$ ist, *F_{ce}* eine vorbestimmte Mittenfrequenz bezeichnet und *BW_{chirp}* die Bandbreite des CHIRP bezeichnet; und
die Frequenzpositionnierung des eingespeisten Kalibrierungssignals vom Typ CHIRP von der Frequenzebene der Verkehrsträger unabhängig ist.

14. System zur Kalibrierung eines Hochfrequenz-Mehrkanal-Subsystems nach einem der Ansprüche 12 bis 13, wobei:
die erste und die zweite Vorrichtung (212; 214) so konfiguriert sind, dass sie Kalibrierungssignale erzeugen und an einem vorbestimmten Einspeisepunkt eines Eingangszugriffskanals oder an mehreren vorbestimmten Punkten, die jeweils einem anderen Eingangszugriffskanal zugeordnet sind, einspeisen, und
die eingespeisten Kalibrierungssignale Signale vom Typ "CHIRP" gleicher Bandbreite sind, die auf unterschiedliche Mittenfrequenzen zentriert sind und die gleichmäßig über das Kommunikationsband der Verkehrsträger verteilt sind.

15. System zur Kalibrierung eines Hochfrequenz-Mehrkanal-Subsystems nach einem der Ansprüche 12 bis 14, wobei:
wenn die Telekommunikationsnutzlast vollständig in einem Satelliten enthalten und an Bord desselben untergebracht ist, das Hochfrequenz-Mehrkanalsystem Folgendes ist
ein MPA, der zwei Butler-Matrizen umfasst, wobei die digitale oder analoge Butler-Eingangsmatrix, ohne Strahlformungsnetzwerk, BFN, in eine aktive Antenne integriert ist oder nicht; oder
ein MPA mit einem Strahlformungsnetzwerk, BFN, am digitalen oder analogen Eingang und einer Butler-Matrix am Ausgang, der in eine aktive Antenne integriert ist oder nicht; oder
ein parallelgeschalteter Mehrportverstärker, MPPA, der parallelgeschaltete Verstärker innerhalb einer MPA umfasst, in eine aktive Antenne integriert oder nicht; oder
eine halbaktive, sogenannte "Multimatrix"-Antenne mit Reflektor, mit oder ohne MPA; oder
eine aktive Antenne vom Typ Direct Radiation Array, DRA, oder eine Antenne mit einem von einem Quellenarray gespeisten Subreflektor, AFSRA, oder eine Antenne mit an seinem Brennpunkt von einem Quellenarray gespeisten Reflektor, FAFR, mit einem analogen oder digitalen BFN; oder
eine bordseitige Funktion, die die Amplituden-/Phasenkopplung mehrerer Kanäle untereinander erfordert;
und
wenn die Telekommunikationsnutzlast auf einen Satelliten und eine Strahlformungs-Bodenstation verteilt ist, das Hochfrequenz-Mehrkanalsystem Folgendes ist
eine aktive Satellitenantenne im Empfangsmodus, Rx, mit effektiver Strahlformung am Boden, GBBF, oder
eine aktive Satellitenantenne im Sendemodus, Tx, mit effektiver Strahlformung am Boden, GBBF, mit oder ohne vollständig an Bord befindlicher MPA- oder MPPA-Funktion oder mit oder ohne MPA- oder MPPA-Funktion, deren Butler-Eingangsmatrix am Boden verteilt ist.

## Claims

1. Method for calibrating a radiofrequency multichannel subsystem (12; 32; 52; 72; 102; 204) of a telecommunications payload, the payload being entirely included in and carried on board a satellite or distributed over a satellite and a ground beamforming station, the calibration taking place while the payload is in operation,
the multichannel subsystem (12; 32; 52; 72; 102; 204) comprising:
.- a first integer number N, greater than or equal to 2, of input access channels, and
.- a second integer number M, greater than or equal to 1, of output access channels, and
.- a set (26; 46; 66; 96; 126) of at least two internal channels, each formed by a chain of radiofrequency components having the same architecture, either distributing a same input signal supplied by an input access channel over several output access channels, or combining several input signals supplied respectively by several input access channels onto a same output access channel,
the calibration method comprising:
.- a first step (304) of generating and injecting a calibration signal at a predetermined injection point of an input access channel or at several predetermined points each associated with a different input access channel, then
.- a second step (306) of extracting the injected and propagated calibration signal at a predetermined tapping-off point of an output access channel or at several predetermined tapping-off points each associated with a different output access channel, then
.- a third step (308) of estimating amplitude and/or phase differences between the internal channels of the multichannel subsystem from the calibration signal injected at the input serving as a reference and the extracted calibration signal or signals; then
.- a fourth step (310) of correcting the amplitude and/or phase differences by one or more means for correcting said differences when one or more of the latter exceed a predetermined threshold;
the calibration method being **characterized in that**:
the injected calibration signal is a "CHIRP"-type signal, composed of one or more same CHIRP patterns in which the frequency varies linearly within a given frequency band ( BW_{chirp} ), **in that** the calibration signal is injected at a power level sufficiently low so as not to degrade the performance of traffic signals transmitted over the access channels, and **in that** the second step (306) of extracting the calibration signal comprises filtering the signal or signals tapped off at one or more output points by a filter matched to the calibration signal.

2. Method for calibrating a radiofrequency multichannel subsystem according to claim 1, wherein each CHIRP pattern of the injected "CHIRP"-type calibration signal is a complex signal s(t) of the form *s*(*t*) *= a*(*t*)*.* exp {*j. φ*(*t*)} where *a*(*t*) ≥ 0 is a low-pass amplitude whose time evolution is slow relative to the oscillations of the phase *φ*(*t*).

3. Method for calibrating a radiofrequency multichannel subsystem according to any one of claims 1 and 2, wherein the injected calibration signal is a periodized complex linear "CHIRP"-type signal s(t) of the form *s*(*t*) = *A ·* exp {*j · φ*(*t*)}, the instantaneous frequency: $f \left(t\right) = \frac{1}{2 π} ∗ \frac{dφ \left(t\right)}{dt} = F 1 + \frac{F 2 - F 1}{T 1} ∗ t$
evolving according to a periodic sawtooth-type function repeating, according to a time period T1, a frequency ramp pattern varying linearly between a first frequency value F1 and a second frequency value F2,
The first frequency value F1 being equal to ${F}_{ce} - \frac{{BW}_{chirp}}{2}$ and the second frequency value F2 being equal to ${F}_{ce} + \frac{{BW}_{chirp}}{2}$, *F_{ce}* designating a predetermined center frequency and *BW_{chirp}* designating the bandwidth of the CHIRP.

4. Method for calibrating a radiofrequency multichannel subsystem according to any one of claims 1 to 3, wherein the frequency positioning of the injected "CHIRP"-type calibration signal is independent of the frequency plan (402) of the traffic carriers.

5. Method for calibrating a radiofrequency multichannel subsystem according to any one of claims 1 to 4, wherein the spectrum of the injected "CHIRP"-type calibration signal comprises a main lobe having a bandwidth *B_{chirp}* and being entirely included within the band of a traffic carrier.

6. Method for calibrating a radiofrequency multichannel subsystem according to any one of claims 1 to 4, wherein the spectrum of the injected "CHIRP"-type calibration signal comprises a main lobe having a bandwidth *B_{chirp}* and being partially included within the band of a traffic carrier.

7. Method for calibrating a radiofrequency multichannel subsystem according to any one of claims 1 to 4, wherein the spectrum of the injected "CHIRP"-type calibration signal comprises a main lobe having a bandwidth *B_{chirp}* and being entirely included within a guard band of the traffic carriers.

8. Method for calibrating a radiofrequency multichannel subsystem according to any one of claims 1 to 7, wherein
the first step (304) consists in generating and injecting calibration signals at a predetermined injection point of an input access channel or at several predetermined points each associated with a different input access channel, and
the injected calibration signals are "CHIRP"-type signals having the same bandwidth and centered at different center frequencies regularly distributed over the communication band of the traffic carriers.

9. Method for calibrating a radiofrequency multichannel subsystem according to any one of claims 1 to 8, wherein:
the injected calibration signal is a periodized complex linear "CHIRP"-type signal s(t) of the form *s*(*t*) = *A ·* exp {*j · φ*(*t*)}
the instantaneous frequency f(t), expressed by the equations: $f \left(t\right) = \frac{1}{2 π} ∗ \frac{dφ \left(t\right)}{dt} = F 1 + \frac{F 2 - F 1}{T 1} ∗ t$
evolving according to a periodic sawtooth-type function repeating, according to a time period T1, a frequency ramp pattern varying linearly between a first frequency value F1 and a second frequency value F2,
the first frequency value F1 being equal to ${F}_{ce} - \frac{{BW}_{chirp}}{2}$ and the second frequency value F2 being equal to ${F}_{ce} + \frac{{BW}_{chirp}}{2}$, *F_{ce}* designating a predetermined center frequency and *BW_{chirp}* designating the bandwidth of the CHIRP; and
during the third step (308), the amplitude Δ*A* and/or phase Δ*Phi* differences between the internal channels of the multichannel subsystem are estimated from the calibration signal injected at the input serving as a reference and the signal or signals tapped off at the output,
by extracting (452), for each internal channel, the calibration signal from the traffic signal by matched filtering which maximizes the signal-to-noise ratio of the calibration signal and which maximizes a correlation function between the samples of the signal tapped off at the output and the samples of the calibration signal as a reference replica, and
by estimating (454) the amplitude A and the phase Phi of each internal channel from the correlation maximum giving the complex gain and propagation delay of the calibration signal from its digital injection point to the output of the matched filtering; then
by calculating (456) the differences Δ*A*/Δ*Phi* of the internal channels relative to a predetermined reference channel from the estimated amplitude and phase A/Phi of each channel.

10. Method for calibrating a radiofrequency multichannel subsystem according to any one of claims 1 to 8, wherein:
when the telecommunications payload is entirely included in and carried on board a satellite, the radiofrequency multichannel system is
an MPA having two Butler matrices, with the digital or analog input Butler matrix, without a beamforming network BFN, integrated within an active antenna or not; or
an MPA with a beamforming network BFN at the digital or analog input and a Butler matrix at the output, integrated within an active antenna or not; or
a Multi-Port Parallelized Amplifier MPPA comprising parallelized amplifiers within an MPA, integrated within an active antenna or not; or
a so-called "Multimatrix" semi-active antenna with reflector, with or without an MPA; or
an active antenna of the Direct Radiating Array DRA type or an Array Fed Sub-Reflector Antenna AFSRA or a Focal Array Fed Reflector antenna FAFR with an analog or digital BFN; or
an on-board function requiring amplitude/phase matching of several channels with one another;
and
when the telecommunications payload is distributed over a satellite and a ground beamforming station, the radiofrequency multichannel system is
a satellite active antenna in reception mode Rx with effective Ground Based Beam Forming GBBF; or
a satellite active antenna in transmission mode Tx with effective Ground Based Beam Forming GBBF, with or without an MPA or MPPA function entirely on board or with or without an MPA or MPPA function whose input Butler matrix is distributed on the ground.

11. Method for calibrating a radiofrequency multichannel subsystem according to any one of claims 1 to 10, wherein:
the fourth step (310) is performed directly on board the satellite or on the ground.

12. Calibration system for a radiofrequency multichannel subsystem (12; 32; 52; 72; 102; 204) of a telecommunications payload, the payload being entirely included in and carried on board a satellite or distributed over a satellite and a ground beamforming station, the calibration taking place while the payload is in operation,
the multichannel subsystem (12; 32; 52; 72; 102; 204) comprising:
.- a first integer number N, greater than or equal to 2, of input access channels, and
.- a second integer number M, greater than or equal to 2, of output access channels, and
.- a set (26; 46; 66; 96; 126) of at least two internal channels, each formed by a chain of radiofrequency components having the same architecture, either distributing a same input signal supplied by an input access channel over several output access channels, or combining several input signals supplied respectively by several input access channels onto a same output access channel; and
the calibration system comprising
a first device (212) for injecting an analog or digital calibration signal at a predetermined injection point of an input access channel or at several predetermined points each associated with a different input access channel; and
a second device (214) for tapping off the injected and propagated calibration signal at a predetermined tapping-off point of an output access channel or at several predetermined tapping-off points each associated with a different output access channel;
a third digital computing device (216), formed by one or more electronic computers, and configured to:
.- generate a digital calibration signal corresponding to the digital or analog version of the calibration signal injected by the first device; and
.- extract the injected calibration signal from the signal or signals tapped off at the predetermined tapping-off point of an output access channel or at the predetermined tapping-off points each associated with a different output access channel and from the generated calibration signal;
.- estimate amplitude and/or phase differences between the internal channels of the multichannel subsystem from the calibration signal injected at the input serving as a reference and the extracted calibration signal or signals; and
.- correct amplitude and/or phase differences by controlling one or more means for correcting said differences when one or more of said differences exceed a predetermined threshold;
the calibration system being **characterized in that** the injected calibration signal is a "CHIRP"-type signal, composed of one or more same CHIRP patterns of which the frequency varies linearly within a given frequency band ( BW_{chirp} ), **in that** the calibration signal is injected at a power level sufficiently low so as not to degrade the performance of traffic signals transmitted over the access channels, and **in that** the extraction of the calibration signal comprises filtering the signal or signals tapped off at one or more output points by a filter matched to the calibration signal.

13. Calibration system for a radiofrequency multichannel subsystem according to claim 12 wherein
the injected calibration signal is a periodized complex linear "CHIRP"-type signal s(t) of the form *s*(*t*) = *A*. exp {*j. φ*(*t*)},
the instantaneous frequency f(t), defined by the equations: $f \left(t\right) = \frac{1}{2 π} ∗ \frac{dφ \left(t\right)}{dt} = F 1 + \frac{F 2 - F 1}{T 1} ∗ t ,$
evolving according to a periodic sawtooth-type function repeating, according to a time period T1, a frequency ramp pattern varying linearly between a first frequency value F1 and a second frequency value F2,
the first frequency value F1 being equal to ${F}_{ce} - \frac{{BW}_{chirp}}{2}$ and the second frequency value F2 being equal to ${F}_{ce} + \frac{{BW}_{chirp}}{2}$, *F_{ce}* designating a predetermined center frequency and *BW_{chirp}* designating the bandwidth of the CHIRP; and
the frequency positioning of the injected CHIRP-type calibration signal is independent of the frequency plan of the traffic carriers.

14. Calibration system for a radiofrequency multichannel subsystem according to any one of claims 12 to 13, wherein:
the first and second devices (212; 214) are configured to generate and inject calibration signals at a predetermined injection point of an input access channel or at several predetermined points each associated with a different input access channel, and
the injected calibration signals are "CHIRP"-type signals having the same bandwidth and centered at different center frequencies regularly distributed over the communication band of the traffic carriers.

15. Calibration system for a radiofrequency multichannel subsystem according to any one of claims 12 to 14, wherein:
when the telecommunications payload is entirely included in and carried on board a satellite, the radiofrequency multichannel system is
an MPA having two Butler matrices, with the digital or analog input Butler matrix, without a beamforming network BFN, integrated within an active antenna or not; or
an MPA with a beamforming network BFN at the digital or analog input and a Butler matrix at the output, integrated within an active antenna or not; or
a Multi-Port Parallelized Amplifier MPPA having parallelized amplifiers within an MPA, integrated within an active antenna or not; or
a so-called "Multimatrix" semi-active antenna with reflector, with or without an MPA; or
an active antenna of the Direct Radiating Array DRA type or an Array Fed Sub-Reflector Antenna AFSRA or a Focal Array Fed Reflector antenna FAFR with an analog or digital BFN; or
an on-board function requiring amplitude/phase matching of several channels with one another;
and
when the telecommunications payload is distributed over a satellite and a ground beamforming station, the radiofrequency multichannel system is
a satellite active antenna in reception mode Rx with effective Ground Based Beam Forming GBBF; or
a satellite active antenna in transmission mode Tx with effective Ground Based Beam Forming GBBF, with or without an MPA or MPPA function entirely on board or with or without an MPA or MPPA function whose input Butler matrix is distributed on the ground.
